# EUROPEAN PATENT APPLICATION

(11) **EP 4 773 782 A1**
(43) Date of publication of application: **08.07.2026**
(21) Application number: 25225814.0
(22) Date of filing: 19.12.2025
(51) Int. Cl.: H10K 59/38, H10K 59/80

(54) **DISPLAY PANEL AND ELECTRONIC APPARATUS INCLUDING THE SAME**

(30) Priority: 03.01.2025 KR 20250001173
(71) Applicant: Samsung Display Co., Ltd., Yongin-si, Gyeonggi-do 17113 (KR)
(72) Inventor: Hong, Sunghwan, 17113 Yongin-si, Gyeonggi-do, (KR); Kang, Sukhoon, 17113 Yongin-si, Gyeonggi-do (KR); Lim, Ho, 17113 Yongin-si, Gyeonggi-do, (KR)
(74) Representative: Gulde & Partner

(57) **Abstract**

A display panel includes a substrate. A display layer is arranged over the substrate and including a plurality of display elements emitting light of different colors from each other. An encapsulation member is coupled to the substrate and shields the display layer. A light-blocking layer is arranged over the encapsulation member and including a plurality of opening portions respectively corresponding to the plurality of display elements. A plurality of color filters is arranged in the light-blocking layer to respectively correspond to the plurality of display elements. A refractive layer is arranged over the plurality of color filters and has a refractive index in a range of about 1 to about 1.5.

## Description

### CROSS-REFERENCE TO RELATED APPLICATION

This application claims priority under 35 U.S.C. §119 to Korean Patent Application No. 10-2025-0001173, filed on January 3, 2025 in the Korean Intellectual Property Office, the disclosure of which is incorporated by reference in its entirety herein.

### 1. TECHNICAL FIELD

One or more embodiments relate to an apparatus, and more particularly, to a display panel and an electronic apparatus including the same.

### 2. DISCUSSION OF RELATED ART

Portable electronic apparatuses have been widely used along with the advancement of the information society. In addition to small electronic apparatuses such as mobile phones, tablet personal computers (PC) have recently been widely used as portable electronic apparatuses.

Such portable electronic apparatuses include a display panel to provide visual information such as images or videos to a user to support various functions. Recently, as various parts for driving a display panel have been miniaturized, the proportion of a display panel in an electronic apparatus has increased gradually and a structure capable of being bent from a flat state by a certain angle has also been developed.

However, since light emitted from display elements may travel in various directions, a display panel may fail to display a clear image.

### SUMMARY

One or more embodiments include a display panel capable of implementing a clear image and an electronic apparatus including the display panel.

Additional aspects will be set forth in part in the description which follows and, in part, will be apparent from the description, or may be learned by practice of the presented non-limiting embodiments of the disclosure.

According to an embodiment of the present disclosure, a display panel includes a substrate, a display layer arranged over the substrate and including a plurality of display elements emitting light of different colors, an encapsulation member coupled to the substrate to shield the display layer, a light-blocking layer arranged over the encapsulation member and including a plurality of opening portions respectively corresponding to the plurality of display elements, a plurality of color filters arranged in the light-blocking layer to respectively correspond to the plurality of display elements, and a refractive layer arranged over the plurality of color filters and having a refractive index of about 1 to about 1.5.

In an embodiment, the display panel may further include a scattering layer arranged between the light-blocking layer and the encapsulation member and overlapping at least one of the plurality of display elements.

In an embodiment, at least one of the plurality of color filters and/or at least a portion of the light-blocking layer may include scattering particles.

In an embodiment, one surface of at least one of the plurality of color filters may be curved.

In an embodiment, the display panel may further include a water-repellent layer arranged on the light-blocking layer.

In an embodiment, an upper surface of the light-blocking layer may be arranged at a point above or at a same level as a highest point of each of the plurality of color filters.

In an embodiment, the refractive layer may include low-refractive particles.

In an embodiment, the refractive layer may include an upper substrate arranged over the light-blocking layer and spaced apart from each of the plurality of color filters. A gas layer is disposed between the upper substrate and each of the plurality of color filters.

In an embodiment, the display panel may further include an input sensing layer arranged over the refractive layer or between each of the plurality of color filters and the encapsulation member.

According to an embodiment of the present disclosure, a display panel includes a substrate. A display layer is arranged over the substrate and includes a plurality of display elements emitting light of different colors (for example, different from each other). An encapsulation member is coupled to the substrate and shields the display layer. A first light-blocking layer is arranged over the encapsulation member and includes a plurality of first opening portions respectively corresponding to the plurality of display elements. A plurality of color filters is respectively arranged in the plurality of first opening portions to respectively correspond to the plurality of display elements. A second light-blocking layer is arranged over the plurality of color filters and includes a plurality of second opening portions respectively corresponding to the plurality of first opening portions. A refractive layer is arranged in each of the plurality of second opening portions and/or over the plurality of second opening portions and has a refractive index in a range of about 1 to about 1.5.

In an embodiment, the display panel may further include a scattering layer arranged between the first light-blocking layer and the encapsulation member and overlapping at least one of the plurality of display elements.

In an embodiment, at least one of the plurality of color filters, at least a portion of the first light-blocking layer, and/or at least a portion of the second light-blocking layer may include scattering particles.

In an embodiment, the refractive layer may include low-refractive particles.

In an embodiment, the refractive layer may include an upper substrate arranged over the second light-blocking layer and spaced apart from each of the plurality of color filters. A gas layer is disposed over each of the plurality of color filters.

In an embodiment, the display panel may further include an input sensing layer arranged over the refractive layer or between each of the plurality of color filters and the encapsulation member.

According to an embodiment of the present disclosure, an electronic apparatus includes a display panel, and a display circuit board connected to the display panel. The display panel includes a substrate. A display layer is arranged over the substrate and includes a plurality of display elements emitting light of different colors (for example, different from each other). An encapsulation member is coupled to the substrate and shields the display layer. A light-blocking layer is arranged over the encapsulation member and includes a plurality of opening portions respectively corresponding to the plurality of display elements. A plurality of color filters is arranged in the light-blocking layer and is arranged to respectively correspond to the plurality of display elements. A refractive layer is arranged over the plurality of color filters and has a refractive index in a range of about 1 to about 1.5.

In an embodiment, the display panel may further include a scattering layer arranged between the light-blocking layer and the encapsulation member and overlapping at least one of the plurality of display elements.

In an embodiment, at least one of the plurality of color filters and/or at least a portion of the light-blocking layer may include scattering particles.

In an embodiment, the display panel may further include a water-repellent layer arranged on the light-blocking layer.

In an embodiment, the refractive layer may include low-refractive particles.

In an embodiment, the refractive layer may include an upper substrate arranged over the light-blocking layer and spaced apart from each of the plurality of color filters. A gas layer is disposed between the upper substrate and each of the plurality of color filters.

In an embodiment, the display panel may further include an additional light-blocking layer arranged over the plurality of color filters and including a plurality of additional opening portions respectively corresponding to the plurality of opening portions. The refractive layer may be arranged in each of the plurality of additional opening portions and/or over the plurality of additional opening portion.

In an embodiment, at least one of the plurality of color filters, at least a portion of the light-blocking layer, and/or at least a portion of the additional light-blocking layer may include scattering particles.

In an embodiment the refractive layer may include an upper substrate arranged over the additional light-blocking layer and spaced apart from each of the plurality of color filters. A gas layer is disposed over each of the plurality of color filters.

Other aspects, features, and advantages other than those described above will be apparent from the accompanying drawings, the attached claims, and the detailed description of the present disclosure.

### BRIEF DESCRIPTION OF THE DRAWINGS

The above and other aspects, features, and advantages of certain non-limiting embodiments of the present disclosure will be more apparent from the following description taken in conjunction with the accompanying drawings, in which:
FIG. 1 is a block diagram of an electronic apparatus according to an embodiment of the present disclosure;
FIGS. 2 to 4 are schematic diagrams of electronic apparatuses according to various embodiments of the present disclosure;
FIG. 5 is a perspective view schematically illustrating an electronic apparatus according to an embodiment of the present disclosure;
FIG. 6 is an exploded perspective view schematically illustrating the electronic apparatus of FIG. 5 according to an embodiment of the present disclosure;
FIG. 7 is a plan view schematically illustrating a portion of the display panel of FIG. 6 according to an embodiment of the present disclosure;
FIG. 8 is a circuit diagram schematically illustrating a subpixel circuit of a subpixel arranged in a display area of FIG. 7 according to an embodiment of the present disclosure;
FIGS. 9A to 9D are cross-sectional views schematically illustrating a portion of the display apparatus of FIG. 6 according to embodiments of the present disclosure;
FIGS. 10A to 10D are cross-sectional views schematically illustrating a portion of a display apparatus according to embodiments of the present disclosure;
FIG. 11 is a cross-sectional view schematically illustrating a portion of a display apparatus according to an embodiment of the present disclosure;
FIGS. 12A and 12B are cross-sectional views schematically illustrating a portion of a display apparatus according to embodiments of the present disclosure;
FIGS. 13A and 13B are cross-sectional views schematically illustrating a portion of a display apparatus according to embodiments of the present disclosure;
FIGS. 14A and 14B are cross-sectional views schematically illustrating a portion of a display apparatus according to embodiments of the present disclosure;
FIGS. 15A and 15B are cross-sectional views schematically illustrating a portion of a display apparatus according to embodiments of the present disclosure;
FIG. 16 is a cross-sectional view schematically illustrating a portion of a display apparatus according to an embodiment of the present disclosure;
FIG. 17 is a cross-sectional view schematically illustrating a portion of a display apparatus according to an embodiment of the present disclosure;
FIGS. 18A to 18D are cross-sectional views schematically illustrating a portion of a display apparatus according to embodiments of the present disclosure;
FIGS. 19A to 19D are cross-sectional views schematically illustrating a portion of a display apparatus according to embodiments of the present disclosure; and
FIGS. 20A to 20D are cross-sectional views schematically illustrating a portion of a display apparatus according to embodiments of the present disclosure.

### DETAILED DESCRIPTION OF EMBODIMENTS

Reference will now be made in detail to non-limiting embodiments, examples of which are illustrated in the accompanying drawings, wherein like reference numerals refer to like elements throughout. In this regard, embodiments of the present disclosure may have different forms and should not be construed as being limited to the descriptions set forth herein. Accordingly, non-limiting embodiments are merely described below, by referring to the figures, to explain aspects of the present disclosure. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

The present disclosure may include various embodiments and modifications, and particular embodiments thereof are illustrated in the drawings and will be described herein in detail. The effects and features of the present disclosure and methods of achieving them will become apparent with reference to embodiments described below in detail together with the drawings. However, the present disclosure is not limited to the embodiments described below and may be implemented in various forms.

Hereinafter, embodiments will be described in detail with reference to the accompanying drawings, and in the following description, like reference numerals will denote like elements and redundant descriptions thereof will be omitted for conciseness.

It will be understood that although terms such as "first" and "second" may be used herein to describe various elements, these elements should not be limited by these terms and these terms are only used to distinguish one element from another element.

As used herein, the singular forms "a," "an," and "the" are intended to include the plural forms as well, unless the context clearly indicates otherwise.

It will be understood that terms such as "comprise," "include," and "have" used herein specify the presence of stated features or elements, but do not preclude the presence or addition of one or more other features or elements.

It will be understood that when a layer, region, or component is referred to as being "on" another layer, region, or component, it may be "directly on" the other layer, region, or component or may be "indirectly on" the other layer, region, or component with one or more intervening layers, regions, or components therebetween. When a layer, region, or component is referred to as being "directly on" another layer, region, or component, no intervening layers, regions, or components may be present.

Sizes of components in the drawings may be exaggerated for convenience of description. In other words, because the sizes and shapes of components in the drawings may be arbitrarily illustrated for convenience of description, embodiments of the present disclosure are not necessarily limited thereto.

Also, herein, the x axis, the y axis, and the z axis are not necessarily limited to three axes of the rectangular coordinate system and may be interpreted in a broader sense. For example, the x axis, the y axis, and the x axis may be perpendicular to one another or may represent different directions that are not perpendicular to one another.

When a certain embodiment may be implemented differently, a particular process order may be performed differently from the described order. For example, two consecutively described processes may be performed substantially at the same time or performed in an order opposite to the described order.

The present disclosure concerns a display panel that includes a light-blocking layer having a plurality of color filters arranged to respectively correspond to emission areas of the subpixels. In some embodiments, a refractive layer arranged over the color filters has a refractive index in a range of about 1 to about 1.5, for example, a lower boundary of the range of the refractive index may be 1, 1.1 or 1.2, and an upper boundary of the range of the refractive index may be 1.3, 1,4 1.5 or 1.6. In some embodiments a gas layer may be disposed over each of the plurality of color filters.

The plurality of color filters in the light-blocking layer increases the front transmittance of light transmitted through the front of the display layer and increases the clarity of the image. Scattering particles may be included in at least one of the color filters or a portion of the light-blocking layer. The scattering particles increase the brightness of the light emitted by the subpixels.

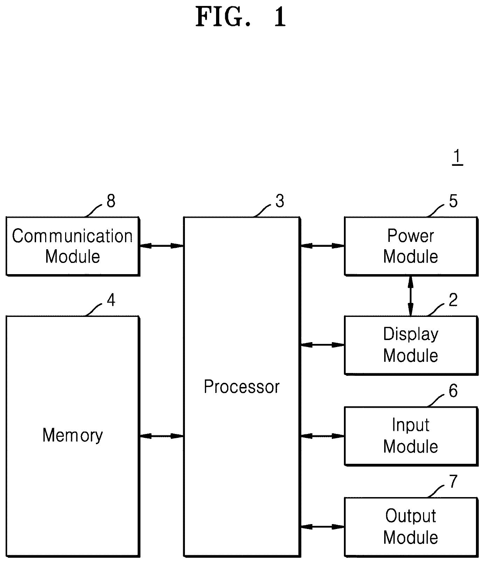

FIG. 1 is a block diagram of an electronic apparatus according to an embodiment.

Referring to FIG. 1, an electronic apparatus 1 according to an embodiment may include a display module 2 including a display panel, a processor 3, a memory 4, and a power module 5.

The processor 3 may include at least one of a central processing unit (CPU), an application processor (AP), a graphic processing unit (GPU), a communication processor (CP), an image signal processor (ISP), and a controller. In an embodiment, the processor 3 may be divided into two or more processors from a functional or structural viewpoint. For example, the processor 3 may include a main processor in the form of a first driving chip including a CPU and an auxiliary processor in the form of a second driving chip including a controller that receives an image signal from the main processor and processes the image signal in accordance with the interface specifications of the display module 2.

The memory 4 may include at least one of a nonvolatile memory and a volatile memory. The memory 4 may store data information necessary for the operation of the processor 3 or the display module 2. When the processor 3 executes an application stored in the memory 4, an image data signal and/or an input control signal may be transmitted to the display module 2 and the display module 2 may process the received signal and output image information through a display screen.

In an embodiment, the power module 5 may include a power supply module such as a power adapter or a battery device, and a power conversion module that converts the power supplied by the power supply module to generate power necessary for the operation of the electronic apparatus 1. The power conversion by the power conversion module may include, but is not necessarily limited to, DC-DC conversion, AC-DC conversion, and DC-AC conversion.

The electronic apparatus 1 may further include an input module 6, an output module (e.g. non-image output module) 7, and/or a communication module 8.

The input module 6 may provide input information to the processor 3 and/or the display module 2. The input module 6 may include various sensor modules as well as physical buttons, a keyboard, and a microphone. Examples of the sensor modules may include, but are not necessarily limited to, a touch sensor, a pressure sensor, a distance sensor, a position sensor, a digitizer, a motion recognition sensor, a camera sensor, a light receiving sensor, a photoelectric conversion sensor, and a temperature sensor as well as biometric sensors such as a blood pressure sensor, a blood sugar sensor, an electrocardiogram sensor, and a heart rate sensor.

The non-image output module 7 may receive information other than the image from the processor 3 and provide the information to the user. Examples of the non-image output module 7 may include an audio module, a haptic module, and a light emitting module and may include other functional modules unique to the electronic apparatus 1(e.g., a cooling module of a refrigerator).

The communication module 8 may be a module managing transmission/reception of information between the electronic apparatus 1 and an external device and may include a receiver and a transmitter. The communication module 8 may include various wireless communication modules such as a mobile communication module, a WiFi module, and a Bluetooth module or various wired communication modules.

At least one of the components of the electronic apparatus 1 described above may be included in a display apparatus according to embodiments described below. Also, some of the individual modules functionally included in one module may be included in the display apparatus, and some others thereof may be provided separately from the display apparatus. For example, the display apparatus may include the display module 2, and the processor 3, the memory 4, and the power module 5 may be provided in the form of other devices in the electronic apparatus 1 that is not the display apparatus. As another example, the power module 5 may be arranged in the display apparatus and may supply power to the processor 3 and the memory 4 provided in the electronic apparatus 1 that is not the display apparatus; however, embodiments of the present disclosure are not necessarily limited thereto.

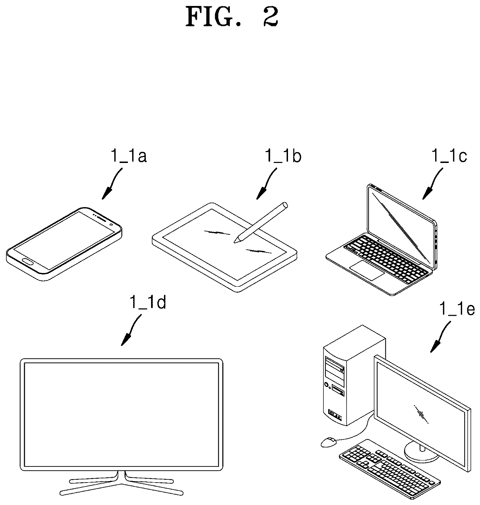

FIGS. 2 to 4 are schematic diagrams of electronic apparatuses according to various embodiments. FIGS. 2 to 4 illustrate examples of various electronic apparatuses to which display apparatuses according to embodiments are applied.

FIG. 2 illustrates a smart phone 1_1a, a tablet personal computer (PC) 1_1b, a laptop 1_1c, a television (TV) 1_1d, and a computer monitor 1_1e as examples of the electronic apparatuses. However, embodiments of the present disclosure are not necessarily limited thereto and the display apparatuses may be applied to various different small-sized, medium-sized or large-sized electronic apparatuses.

The smart phone 1_1a may include an input module such as a touch sensor and a communication module in addition to the display module 2. The smart phone 1_1a may process information received through the communication module or input modules and display the processed information through the display module of the display apparatus.

Similarly to the smart phone 1_1a, the tablet PC 1_1b, the laptop 1_1c, the TV 1_1d, and the computer monitor 1_1e may also include a display module and an input module and may further comprise a communication module in some cases.

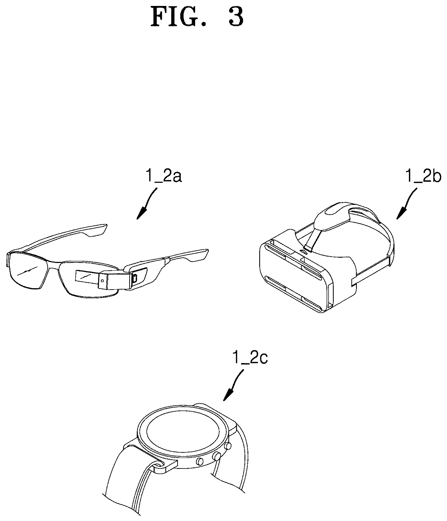

FIG. 3 illustrates a case where an electronic apparatus including a display module is applied to a wearable electronic apparatus. In an embodiment, the wearable electronic apparatus may be smart glasses 1_2a, a head-mounted display 1_2b, a smart watch 1_2c, or the like.

The smart glasses 1_2a and the head-mounted display 1_2b may include a display module that emits a display image and a reflector that reflects an emitted display image to provide the same to the user's eyes, thereby providing a virtual reality or augmented reality screen to the user.

The smart watch 1_2c may include a biometric sensor as an input device and may provide biometric information recognized by the biometric sensor to the user through a display module.

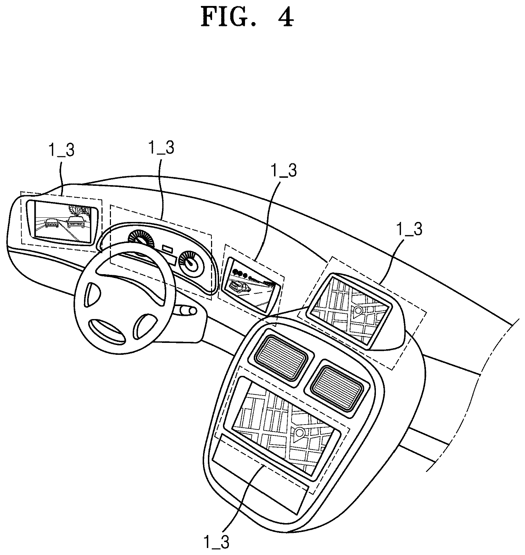

FIG. 4 illustrates a case where an electronic apparatus including a display module is applied to a vehicle. For example, an electronic apparatus 1_3 may be applied to a dashboard, a center fascia, or the like of a vehicle or may be applied to a center information display (CID) arranged on a dashboard of a vehicle, a room mirror display replacing a side mirror, or the like.

In some embodiments, the electronic apparatuses to which the display apparatus is applied may include not only apparatuses that mainly display screens, such as billboards, electronic display boards, and game consoles, but also various home appliances that display information through display modules, such as refrigerators, washing machines, dryers, air conditioners, and robot vacuum cleaners. Also, when the display module has a function of transmitting light, it may be applied to electronic apparatuses such as a smart window or a transparent display apparatus that displays a background and display images together. The types of the electronic apparatus according to embodiments are not necessarily limited to the above illustration, and the disclosure may also be applied to various other electronic apparatuses that are not illustrated.

Hereinafter, for convenience of description, a detailed description will be given mainly of a case where the electronic apparatus 1 is a smart phone.

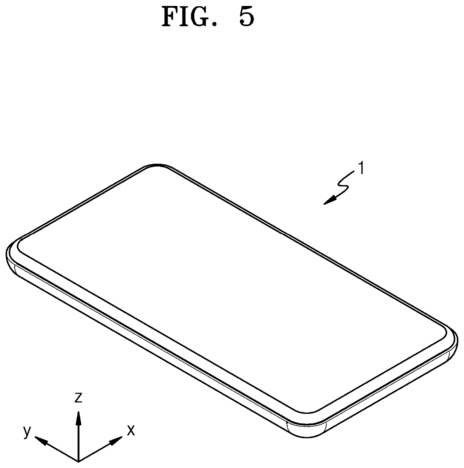

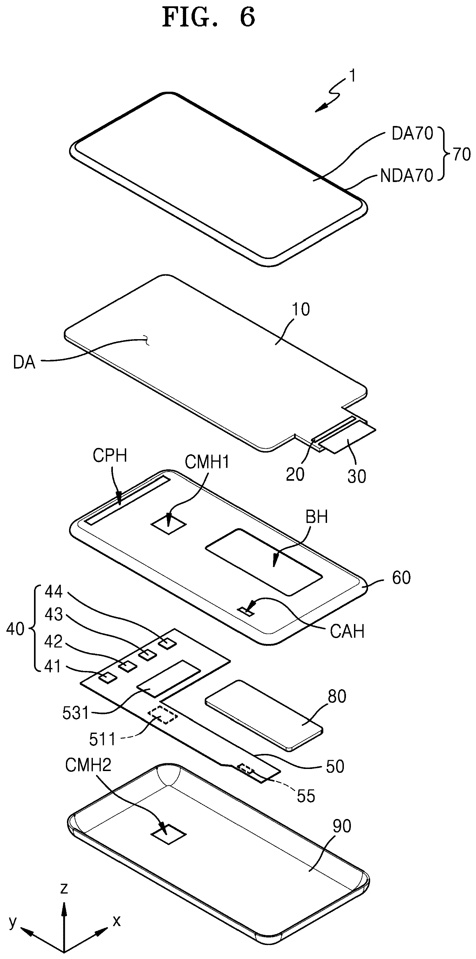

FIG. 5 is a perspective view schematically illustrating an electronic apparatus according to an embodiment. FIG. 6 is an exploded perspective view schematically illustrating the electronic apparatus illustrated in FIG. 5.

Referring to FIGS. 5 and 6, in some embodiments the electronic apparatus 1 may include a display apparatus including a cover window 70, a display panel 10, a data driver 20, and a display circuit board 30, a component 40, a bracket 60, a main circuit board 50, a battery 80, and/or a lower cover 90.

In a plan view herein, "left," "right," "up," and "down" may refer to directions when viewing the display panel 10 in a vertical direction of the display panel 10. For example, "left" may refer to the -x direction, "right" may refer to the +x direction, "up" may refer to the +y direction, and "down" may refer to the -y direction.

In an embodiment, the electronic apparatus 1 may have a substantially rectangular shape in the plan view. For example, the electronic apparatus 1 may have a substantially rectangular shape having a short side in the x-axis direction (e.g., an x direction) and a long side in the y-axis direction (e.g., a y direction) on the xy-plane as illustrated in FIG. 5. In this embodiment, the corner where the short side in the x-axis direction and the long side in the y-axis direction meet each other may form a right angle or may have a round shape to have a certain curvature. Also, in the plan view, the electronic apparatus 1 may have a polygonal shape other than a rectangular shape or may have an elliptical shape, an atypical shape, or the like.

The cover window 70 may be arranged over the display panel 10 (e.g., in the z direction) so as to cover the upper surface of the display panel 10. The cover window 70 may protect the upper surface of the display panel 10.

In an embodiment, the cover window 70 may include a light-transmitting cover unit DA70 corresponding to the display panel 10 and a light-blocking cover unit NDA70 surrounding the light-transmitting cover unit DA70 (e.g., in a plan view). The light-blocking cover unit NDA70 may include an opaque material (e.g., a colored opaque material) that blocks light. The light-blocking cover unit NDA70 may include a pattern that may be shown to the user when an image is not displayed.

The display panel 10 may be arranged under the cover window 70 (e.g., in the -z direction). The display panel 10 may overlap the light-transmitting cover unit DA70 of the cover window 70 (e.g., in the -z direction). The display panel 10 may include a display area DA. The display area DA may be an area where an image is displayed, and the display area DA may include an area (or referred to as a component area) that transmits light emitted from the component 40 arranged under the display panel 10. The component 40 may include a sensor or a camera that uses visible light, infrared light, or sound.

The display panel 10 may be a light emitting display panel including a light emitting diode. In an embodiment, the light emitting diode may be an organic light emitting diode including an organic material or may be an inorganic light emitting diode including an inorganic material. In the case of the inorganic light emitting diode, it may include a PN junction diode including inorganic semiconductor-based materials. When a forward voltage is applied to the PN junction diode, holes and electrons may be injected thereinto and energy generated by the recombination of the holes and electrons may be converted into light energy to emit light of a certain color. The inorganic light emitting diode may have a width of several micrometers to several hundred micrometers. The inorganic light emitting diode may be referred to as a micro LED.

The display panel 10 may be a rigid display panel that is rigid and thus is not easily bent or may be a flexible display panel that is flexible and thus may be easily bent, folded, or rolled. For example, the display panel 10 may be a foldable display panel that may be folded and unfolded, may be a curved display panel with a curved display surface, may be a bent display panel with an area other than a display surface bent, may be a rollable display panel that may be rolled or unrolled, or may be a stretchable display panel that may be stretched.

The display panel 10 may be a transparent display panel that is transparently implemented such that an object or background arranged on the lower surface of the display panel 10 may be viewed from the upper surface of the display panel 10. Alternatively, the display panel 10 may be a reflective display panel that may reflect an object or background on the upper surface of the display panel 10.

In an embodiment, the data driver 20 may be mounted on the display panel 10 in the form of an integrated circuit (IC). However, embodiments of the present disclosure are not necessarily limited thereto, and for example, the data driver 20 may be mounted on the display circuit board 30.

The display circuit board 30 may be attached to one side of the display panel 10. The display circuit board 30 may be a flexible printed circuit board (FPCB) that may be bent, may be a rigid printed circuit board (PCB) that is rigid and thus is not easily bent, or may be a composite printed circuit board including both a rigid printed circuit board and an FPCB. A touch sensor driver may be mounted on the display circuit board 30. In an embodiment, the touch sensor driver may be formed as an integrated circuit. The touch sensor driver may be electrically connected to touch electrodes of a touch screen layer of the display panel 10 through the display circuit board 30.

The touch screen layer of the display panel 10 may detect a user's touch input by using at least one of various touch methods such as a resistive method and a capacitive method. When the touch screen layer of the display panel 10 detects a user's touch input by the capacitive method, the touch sensor driver may apply driving signals to driving electrodes among the touch electrodes and detect voltages charged in mutual electrostatic capacitances (hereinafter referred to as "mutual capacitances") between driving electrodes and sensing electrodes through sensing electrodes among the touch electrodes, thereby determining whether a user's touch has occurred.

The user's touch may include a contact touch and a proximity touch. The contact touch may mean that a user's finger or an object such as a pen directly contacts the cover window 70 arranged over the touch screen layer. The proximity touch may mean that a user's finger or an object such as a pen is located close to and spaced apart from the cover window 70, such as hovering. The touch sensor driver may transmit sensor data (or sensing data) to a main processor 511 according to the detected voltages, and the main processor 511 may calculate touch coordinates of the touch input by analyzing the sensor data.

A controller for supplying driving voltages for driving subpixels, a gate driver, and/or the data driver 20 of the display panel 10 may be arranged over the display circuit board 30.

The bracket 60 for supporting the display panel 10 may be arranged under the display panel 10 (e.g., in the -z direction). The bracket 60 may include plastic, metal, or both plastic and metal. In an embodiment, the bracket 60 may include a first camera hole CMH1 into which a camera device 531 is inserted, a battery hole BH in which the battery 80 is arranged, a cable hole CAH through which a cable connected to the display circuit board 30 passes, and a component hole CPH corresponding to components 40. The component hole CPH may overlap the components 40 of the main circuit board 50 when viewed in a third direction (e.g., the z-axis direction or z direction). For reference, the display area DA of the display panel 10 may overlap the components 40 of the main circuit board 50 when viewed in the third direction (e.g., the z-axis direction). However, in some embodiments the bracket 60 may not include the component hole CPH.

The components 40 included in the electronic apparatus 1 may include a first component 41, a second component 42, a third component 43, and a fourth component 44 that overlap the display panel 10. Each of the first component 41, the second component 42, the third component 43, and the fourth component 44 may include at least one of a proximity sensor, an illumination sensor, an iris sensor, a face recognition sensor, and a camera (e.g., an image sensor). The proximity sensor using infrared rays may detect an object located close to the upper surface of the electronic apparatus 1, and the illumination sensor may sense the brightness of light incident on the upper surface of the electronic apparatus 1. Also, the iris sensor may photograph a person's iris located over the upper surface of the electronic apparatus 1, and the camera may obtain image data about an object arranged over the upper surface of the electronic apparatus 1. However, the components 40 are not necessarily limited to a proximity sensor, an illumination sensor, an iris sensor, a face recognition sensor, and/or a camera and may include other sensors.

The main circuit board 50 and the battery 80 may be arranged under the bracket 60 (e.g., in the -z direction). The main circuit board 50 may be a rigid printed circuit board or an FPCB.

In an embodiment, the main circuit board 50 may include a main processor 511, a camera device 531, a main connector 55, and components 40. The main processor 511 may include an integrated circuit. In some embodiments, the electronic apparatus 1 may also include a camera device arranged on the lower surface of the main circuit board 50, as well as the camera device 531 arranged on the upper surface of the main circuit board 50. Each of the main processor 511 and the main connector 55 may be arranged on any one of the upper surface and the lower surface of the main circuit board 50. The main circuit board 50 may be electrically connected to the display circuit board 30 through the main connector 55 or the like.

The main processor 511 may control all functions of the electronic apparatus 1. For example, the main processor 511 may output digital video data to the data driver 20 through the display circuit board 30 such that the display panel 10 may display an image. The main processor 511 may receive sensing data from the touch sensor driver. The main processor 511 may determine whether there is a user contact based on the sensing data and execute an operation corresponding to the user's direct touch or proximity touch. In an embodiment, the main processor 511 may be an application processor, a central processing unit, or a system chip including an integrated circuit.

The camera device 531 may process an image frame such as a still image or a moving image obtained by an image sensor in a camera mode and output the processed image frame to the main processor 511. The camera device 531 may include at least one of a camera sensor (e.g., CCD or CMOS), a photo sensor (or an image sensor), and a laser sensor.

A cable passing through the cable hole CAH of the bracket 60 may be connected to the main connector 55, and the main circuit board 50 may be electrically connected to the display circuit board 30 through the cable.

In some embodiments, the electronic apparatus 1 may include a wireless communicator, an input unit, a sensor unit, an output unit, an interface unit, a memory, and/or a power supply unit in addition to the main processor 511.

The wireless communicator may include at least one of a broadcast receiving module, a mobile communication module, a wireless Internet module, a short-range communication module, and a position information module.

The broadcast receiving module may receive broadcast signals and/or broadcast-related information from an external broadcast management server through broadcast channels. The broadcast channels may include satellite channels and terrestrial channels.

The mobile communication module may transmit/receive wireless signals to/from at least one of a base station, an external terminal, and a server in a mobile communication network established according to technology standards or communication methods for mobile communication (e.g., Global System for Mobile communication (GSM), Code Division Multi Access (CDMA), Code Division Multi Access 2000 (CDMA2000), Enhanced Voice-Data Optimized or Enhanced Voice-Data Only (EV-DO), Wideband CDMA (WCDMA), High Speed Downlink Packet Access (HSDPA), High Speed Uplink Packet Access (HSUPA), Long Term Evolution (LTE), and Long Term Evolution-Advanced (LTE-A)). The wireless signals may include various forms of data according to voice call signals, video call signals, or text/multimedia message transmission/reception.

The wireless Internet module may refer to a module for wireless Internet access. The wireless Internet module may be configured to transmit/receive wireless signals in a communication network according to wireless Internet technologies. The wireless Internet technologies may include, for example, Wireless LAN (WLAN), Wireless Fidelity (WiFi), WiFi Direct, and/or Digital Living Network Alliance (DLNA).

The short-range communication module may be for short-range communication and may support short-range communication by using at least one of Bluetooth^{™}, Radio Frequency Identification (RFID), Infrared Data Association (IrDA), Ultra Wideband (UWB), ZigBee, Near Field Communication (NFC), Wireless Fidelity (WiFi), WiFi Direct, and Wireless Universal Serial Bus (Wireless USB) technologies. The short-range communication module may support wireless communication between the electronic apparatus 1 and a wireless communication system, between the electronic apparatus 1 and another electronic apparatus, or between the electronic apparatus 1 and a network in which another electronic apparatus (or an external server) is located, through a short-range wireless communication network (Wireless Area Network). The short-range wireless communication network may be a short-range wireless personal area network (Wireless Personal Area Network). The other electronic apparatus may be a wearable device capable of exchanging data (or capable of interoperating) with the electronic apparatus 1.

The position information module may be a module for obtaining the position of the electronic apparatus 1 and may include a Global Positioning System (GPS) module or a Wireless Fidelity (WiFi) module.

The input unit may include an image input unit such as a camera device 531 for inputting an image signal, an audio input unit such as a microphone for inputting an audio signal, and an input device for receiving information from the user. The camera device 531 may process an image frame such as a still image or a moving image obtained by an image sensor in a video call mode or a photographing mode. The processed image frame may be displayed on the display panel 10 or stored in the memory. The microphone may process an external audio signal into electrical voice data. The processed voice data may be variously used depending on the functions performed (or the applications executed) in the electronic apparatus 1.

The main processor 511 may control an operation of the electronic apparatus 1 to correspond to information input through the input device. In an embodiment, the input device may include a mechanical input unit (such as a button, a dome switch, a jog wheel, or a jog switch) or a touch input unit located on the rear surface or side surface of the electronic apparatus 1. The touch input unit may include a touch screen layer of the display panel 10.

The sensor unit may include one or more sensors that sense at least one of information in the electronic apparatus 1, information about the environment surrounding the electronic apparatus 1, and user information and generate a sensing signal corresponding thereto. The main processor 511 may control the driving or operation of the electronic apparatus 1 based on the sensing signal or perform data processing, functions, or operations related to the application installed on the electronic apparatus 1. The sensor unit may be a proximity sensor, an illumination sensor, or a face recognition sensor as described above with respect to the component 40. Also, the sensor unit may include an acceleration sensor, a magnetic sensor, a gravity sensor (G-sensor), a gyroscope sensor, a motion sensor, an RGB sensor, an infrared sensor (IR sensor), a fingerprint recognition sensor (finger scan sensor), an ultrasonic sensor, an optical sensor, and/or a battery gauge. In addition, the sensor unit may include an environmental sensor or a chemical sensor. The environmental sensor may be, for example, a barometer, a hygrometer, a thermometer, a radiation detection sensor, a heat detection sensor, and/or a gas detection sensor. The chemical sensor may be, for example, an electronic nose, a healthcare sensor, and/or a biometric sensor.

The output unit may be for generating an output related to visual, auditory or tactile sensation and may include at least one of a display panel 10, an audio output unit, a haptic module, and a light output unit.

The display panel 10 may display (e.g., output) information processed in the electronic apparatus 1. For example, the display panel 10 may display execution screen information of an application driven in the electronic apparatus 1, display a user interface (UI) according to the execution screen information, or display graphical user interface (GUI) information. The display panel 10 may include a display layer for displaying an image and a touch screen layer for detecting a user's touch input. Accordingly, the display panel 10 may function as one of input devices providing an input interface between the electronic apparatus 1 and the user and may simultaneously function as one of output units (or output devices) providing an output interface between the electronic apparatus 1 and the user.

The audio output unit may output audio data received from the wireless communicator or stored in the memory, in a call signal reception mode, a call mode, a recording mode, a voice recognition mode, and/or a broadcast reception mode. The audio output unit may also output an audio signal related to a function performed in the electronic apparatus 1 (e.g., a call signal reception sound or a message reception sound). The audio output unit may include a receiver and a speaker. At least one of the receiver and the speaker may be an audio generating device that is attached to the lower portion of the display panel 10 and vibrates the display panel 10 to output audio. The audio generating device may be a piezoelectric element or a piezoelectric actuator that contracts and expands according to an electric signal or may be an exciter that vibrates the display panel 10 by generating a magnetic force by using a voice coil.

The haptic module may generate various haptic effects that the user may feel. The haptic module may provide a vibration as a haptic effect to the user. The haptic module not only may transmit a haptic effect through direct contact but also may be implemented such that the user may feel a haptic effect through a muscle sense of the fingers, arms, or the like.

The light output unit may output a signal for notifying the occurrence of an event by using light of a light source. Examples of the event occurring in the electronic apparatus 1 may include message reception, call signal reception, missed call, alarm, schedule notification, email reception, and/or information reception through an application. The signal output from the light output unit may be implemented by the electronic apparatus 1 emitting light of a single color or a plurality of colors from the front surface or rear surface. The signal output may be terminated when the electronic apparatus 1 detects the user's identification of an event.

The interface unit may function as a path for various types of external devices connected to the electronic apparatus 1. The interface unit may include at least one of a wired/wireless headset port, an external charger port, a wired/wireless data port, a memory card port, a port for connecting a device including an identification module, an audio input/output (I/O) port, a video input/output (I/O) port, and an earphone port. When an external device is connected to the interface unit, the electronic apparatus 1 may perform suitable control related to the connected external device.

The memory may store data for supporting various functions of the electronic apparatus 1. The memory may store a plurality of applications (e.g., application programs) driven in the electronic apparatus 1, data for the operation of the electronic apparatus 1, and/or instructions. At least some of the plurality of applications may be downloaded from an external server through wireless communication. The memory may store an application for the operation of the main processor 511 and may temporarily store input/output data such as a phonebook, a message, a still image, and/or a moving image. Also, the memory may store haptic data for various patterns of vibration provided to the haptic module and audio data about various sounds provided to the audio output unit.

The memory may include at least one type of storage medium from among flash memory type, hard disk type, solid state disk (SSD) type, silicon disk drive (SDD) type, multimedia card micro type, card type memory (e.g., SD and XD memories), random-access memory (RAM), static random-access memory (SRAM), read-only memory (ROM), electronically erasable programmable read-only memory (EEPROM), programmable read-only memory (PROM), magnetic memory, magnetic disk, and optical disk.

Under the control by the main processor 511, the power supply unit may receive external power and/or internal power and supply the power to each of the components included in the electronic apparatus 1. The power supply unit may include the battery 80. Also, the power supply unit may include a connection port, and the connection port may be an example of the interface unit to which an external charger supplying power for charging the battery is electrically connected. Alternatively, the power supply unit may allow the battery 80 to be wirelessly charged. The battery 80 may be arranged so as not to overlap the main circuit board 50 in the third direction (e.g., the z-axis direction). The battery 80 may overlap the battery hole BH of the bracket 60.

In an embodiment, the lower cover 90 may form the external shape of the electronic apparatus 1 and may include an opening that exposes a portion of the display panel 10. The lower cover 90 may have an open shape corresponding to the display panel 10 and may be fastened to the display panel 10. The lower cover 90 may be located on the opposite side of the cover window 70 with the display panel 10 therebetween (e.g., in the z direction). The lower cover 90 may be arranged under the main circuit board 50 and the battery 80 (e.g., in the -z direction). The lower cover 90 may be fastened and fixed to the bracket 60. The lower cover 90 may form the external shape of the lower surface of the electronic apparatus 1. The lower cover 90 may include plastic, metal, or both plastic and metal.

A second camera hole CMH2 may be formed in the lower cover 90 to expose the lower surface of the camera device 531. The position of the camera device 531 and the positions of the first camera hole CMH1 and the second camera hole CMH2 corresponding to the camera device 531 are not necessarily limited to those illustrated in FIG. 6 and may be variously modified.

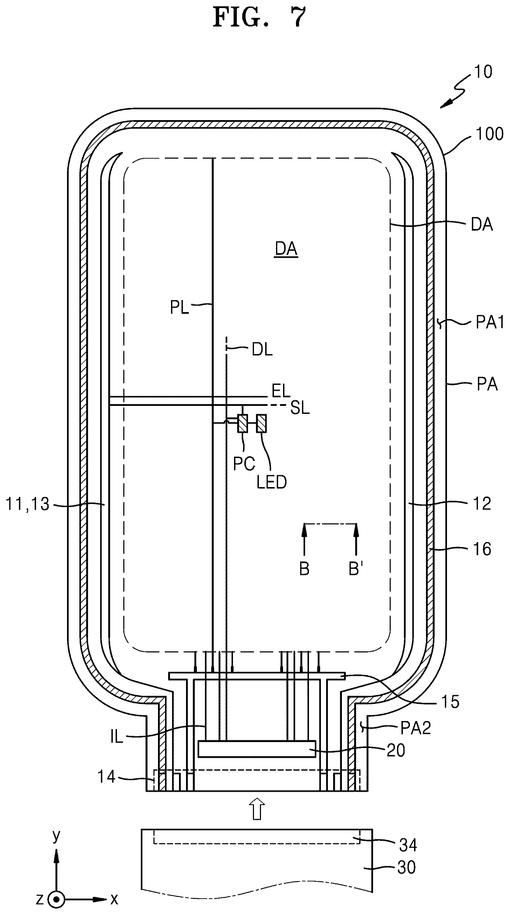

FIG. 7 is a plan view schematically illustrating a portion of the display panel illustrated in FIG. 6.

Referring to FIG. 7, the display panel 10 may include a display area DA and a peripheral area PA outside the display area DA (e.g., in a plan view). The display area DA may be an area for displaying an image, and a plurality of subpixels may be arranged in the display area DA. For example, the display area DA may have any of various shapes such as a circular shape, an elliptical shape, a polygonal shape, and a particular figure shape (e.g., in a plan view). FIG. 7 illustrates that the display area DA has a substantially rectangular shape with rounded corners.

The peripheral area PA may be located outside the display area DA (e.g., in a plan view). In an embodiment, the peripheral area PA may include a first peripheral area PA1 arranged to surround at least a portion of the display area DA and a second peripheral area PA2 located under the display area DA (e.g., in the -y direction) and extending in the first direction (e.g., the x-axis direction). The width of the second peripheral area PA2 in the first direction (e.g., the x-axis direction) may be less than the width of the display area DA (e.g., in the x-axis direction). Through this structure, at least a portion of the second peripheral area PA2 may be easily bent.

The planar shape of the display panel 10 may be substantially the same as the shape of a substrate 100 included in the display panel 10. When the display panel 10 includes the display area DA and the peripheral area PA outside the display area DA (e.g., in a plan view), it may be considered that the substrate 100 includes the display area DA and the peripheral area PA outside the display area DA. Hereinafter, for convenience, it will be described that the substrate 100 includes the display area DA and the peripheral area PA.

The display panel 10 may include a main area in which the display area DA is arranged, a bending area outside the main area, and a subarea spaced apart from the main area with the bending area therebetween (e.g., in the y direction). The main area may be arranged on one side of the bending area, and the subarea may be arranged on the other side of the bending area. The display panel 10 may be bent in the bending area, and at least a portion of the subarea may overlap the main area when viewed in the third direction (z-axis direction). However, embodiments of the present disclosure are not necessarily limited thereto. For example, the display panel 10 may be a foldable display panel, and in this case, the display panel 10 may be bent in the display area DA around a bending axis intersecting the display area DA. However, in some embodiments the display panel 10 may not be bent (e.g., may be rigid and non-bendable). The subarea may be a non-display area NDA.

A data driver 20 may be arranged in the subarea of the display panel 10. In an embodiment, the data driver 20 may be arranged on the display panel 10 in the form of an integrated circuit (IC). For example, the data driver 20 may be a data driving integrated circuit that generates a data signal.

A display circuit board 30 may be attached to an end portion of the subarea of the display panel 10. The display circuit board 30 may be electrically connected to the data driver 20 or the like through a pad 14 of the subarea of the display panel 10.

The display panel 10 may include a substrate 100. Various components included in the display panel 10 may be arranged over the substrate 100.

In an embodiment, the substrate 100 may include glass, ceramic, metal, or polymer resin. The substrate 100 may include a polymer resin such as polyethersulphone, polyacrylate, polyetherimide, polyethylene naphthalate, polyethylene terephthalate, polyphenylene sulfide, polyarylate, polyimide, polycarbonate, and/or cellulose acetate propionate. The substrate 100 may have a multilayer structure including two layers including the polymer resin and an inorganic layer arranged between the two layers. Alternatively, the substrate 100 may have a structure in which layers including the polymer resin and inorganic layers are alternately stacked (e.g., in the z direction). The inorganic layer may include, for example, silicon oxide, silicon nitride, or silicon oxynitride.

Subpixels may be arranged in the display area DA, and the display area DA may provide an image by using light emitted from the subpixels. Each subpixel may include a light emitting diode LED that is a display element, and the light emitting diode LED may be electrically connected to a subpixel circuit PC. The subpixel circuit PC and the light emitting diode LED may be arranged in the display area DA. For convenience, FIG. 7 illustrates that the subpixel circuit PC and the light emitting diode LED are located in parallel (e.g., along the x direction); however, in actuality, the subpixel circuit PC and the light emitting diode LED may at least partially overlap each other (e.g., in the z direction). For example, the light emitting diode LED may be arranged over the subpixel circuit PC.

In an embodiment, a gate driving circuit, a pad 14, a first power supply line 15, and a second power supply line 16 may be arranged in the peripheral area PA. The gate driving circuit may include, for example, a first scan driving circuit 11, a second scan driving circuit 12, and/or an emission control driving circuit 13.

The first scan driving circuit 11 may provide a scan signal to the subpixel circuit PC through a scan line SL. The second scan driving circuit 12 may be arranged on the opposite side of the first scan driving circuit 11 with the display area DA therebetween (e.g., in the x direction). Some of the subpixel circuits PC arranged in the display area DA may be electrically connected to the first scan driving circuit 11, and the others may be connected to the second scan driving circuit 12. However, in some cases, the second scan driving circuit 12 may be omitted.

Like the first scan driving circuit 11, the emission control driving circuit 13 may be arranged on one side of the display area DA. The emission control driving circuit 13 may provide an emission control signal to a subpixel circuit PC through an emission control line EL. FIG. 7 illustrates that the emission control driving circuit 13 is arranged only on one side of the display area DA; however, embodiments of the present disclosure are not necessarily limited thereto. For example, the display panel 10 may include emission control driving circuits 13 arranged on one side and the other side of the display area DA (e.g., in the x direction). Alternatively, the first scan driving circuit 11 may be arranged on one side of the display area DA, and the emission control driving circuit 13 may be arranged on the other side thereof (e.g., in the x direction).

The pad 14 may be arranged in the second peripheral area PA2 of the substrate 100. The pad 14 may be exposed by not being covered by an insulating layer and may be electrically connected to the display circuit board 30. A pad 34 of the display circuit board 30 may be electrically connected to the pad 14 of the display panel 10.

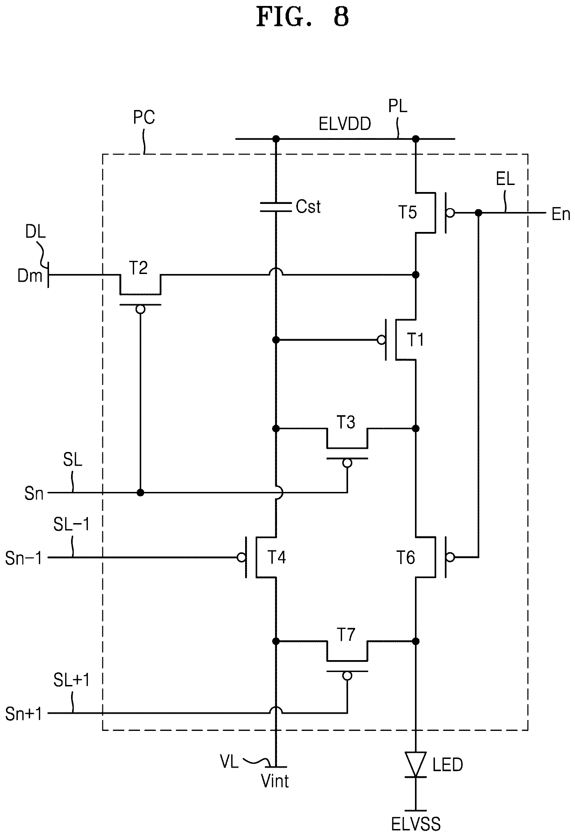

The display circuit board 30 may transmit a signal of a controller or power to the display panel 10. A control signal generated by the controller may be transmitted to each gate driving circuit through the display circuit board 30. Also, the controller may provide a first power voltage ELVDD (see FIG. 8) and a second power voltage ELVSS (see FIG. 8) to the first power supply line 15 and the second power supply line 16, respectively. The first power voltage (or referred to as driving voltage) ELVDD may be provided to each subpixel circuit PC through a driving voltage line PL connected to the first power supply line 15, and the second power voltage (or referred to as common voltage) ELVSS may be provided to a common electrode (e.g., a cathode) of the light emitting diode LED connected to the second power supply line 16. In an embodiment, the first power supply line 15 may extend in the first direction (e.g., the x-axis direction). The second power supply line 16 may have a loop shape with one side open and thus may partially surround the display area DA (e.g., in a plan view).

A data signal of the data driver 20 may be transmitted to the subpixel circuit PC through an input line IL and a data line DL electrically connected to the input line IL.

FIG. 8 is a circuit diagram schematically illustrating a subpixel circuit of a subpixel arranged in a display area illustrated in FIG. 7.

Referring to FIG. 8, the light emitting diode LED may be electrically connected to the subpixel circuit PC.

The subpixel circuit PC may include a first thin film transistor T1, a second thin film transistor T2, a third thin film transistor T3, a fourth thin film transistor T4, a fifth thin film transistor T5, a sixth thin film transistor T6, a seventh thin film transistor T7, and a storage capacitor Cst.

As a switching thin film transistor, the second thin film transistor T2 may be connected to a scan line SL and a data line DL and may be configured to transmit a data voltage (e.g., a data signal) Dm input from the data line DL to the first thin film transistor T1, based on a scan voltage (e.g., a scan signal) Sn input from the scan line SL. The storage capacitor Cst may be connected to the second thin film transistor T1 and a driving voltage line PL and may be configured to store a voltage corresponding to the difference between a voltage received from the second thin film transistor T2 and a first power voltage ELVDD supplied to the driving voltage line PL.

As a driving thin film transistor, the first thin film transistor T1 may be connected to the driving voltage line PL and the storage capacitor Cst and may be configured to control a driving current flowing from the driving voltage line PL through the light emitting diode LED in response to a value of voltage stored in the storage capacitor Cst. The light emitting diode LED may emit light with a certain brightness according to the driving current. A second electrode (e.g., a cathode) of the light emitting diode LED may be supplied with a second power voltage ELVSS.

The third thin film transistor T3 may be a compensation thin film transistor, and the gate electrode of the third thin film transistor T3 may be connected to the scan line SL. The source electrode (or drain electrode) of the third thin film transistor T3 may be connected to the drain electrode (or source electrode) of the first thin film transistor T1 and may be connected to a first electrode of the light emitting diode LED via the sixth thin film transistor T6. The drain electrode (or source electrode) of the third thin film transistor T3 may be connected to one electrode of the storage capacitor Cst, the source electrode (or drain electrode) of the fourth thin film transistor T4, and the gate electrode of the first thin film transistor T1. In an embodiment, the third thin film transistor T3 may be turned on according to a scan signal Sn received through the scan line SL, to connect the gate electrode and the drain electrode of the first thin film transistor T1 to each other to diode-connect the first thin film transistor T1.

The fourth thin film transistor T4 may be an initialization thin film transistor and the gate electrode thereof may be connected to a previous scan line SL-1. The drain electrode (or source electrode) of the fourth thin film transistor T4 may be connected to an initialization voltage line VL. The source electrode (or drain electrode) of the fourth thin film transistor T4 may be connected to the one electrode of the storage capacitor Cst, the drain electrode (or source electrode) of the third thin film transistor T3, and the gate electrode of the first thin film transistor T1. In an embodiment, the fourth thin film transistor T4 may be turned on according to a previous scan signal Sn-1 received through the previous scan line SL-1, to transmit an initialization voltage Vint to the gate electrode of the first thin film transistor T1 to perform an initialization operation of initializing the voltage of the gate electrode of the first thin film transistor T1.

The fifth thin film transistor T5 may be an operation control thin film transistor and the gate electrode thereof may be connected to an emission control line EL. The source electrode (or drain electrode) of the fifth thin film transistor T5 may be connected to the driving voltage line PL. The drain electrode (or source electrode) of the fifth thin film transistor T5 may be connected to the source electrode (or drain electrode) of the first thin film transistor T1 and the drain electrode (or source electrode) of the second thin film transistor T2.

The sixth thin film transistor T6 may be an emission control thin film transistor and the gate electrode thereof may be connected to the emission control line EL. The source electrode (or drain electrode) of the sixth thin film transistor T6 may be connected to the drain electrode (or source electrode) of the first thin film transistor T1 and the source electrode (or drain electrode) of the third thin film transistor T3. The drain electrode (or source electrode) of the sixth thin film transistor T6 may be electrically connected to the first electrode of the light emitting diode LED. In an embodiment, the fifth thin film transistor T5 and the sixth thin film transistor T6 may be simultaneously turned on according to an emission control signal En received through the emission control line EL, such that the first power voltage ELVDD may be transmitted to the light emitting diode LED and the driving current may flow through the light emitting diode LED.

The seventh thin film transistor T7 may be an initialization thin film transistor that initializes the first electrode of the light emitting diode LED. The gate electrode of the seventh thin film transistor T7 may be connected to a next scan line SL+1. The source electrode (or drain electrode) of the seventh thin film transistor T7 may be connected to the first electrode of the light emitting diode LED. The drain electrode (or source electrode) of the seventh thin film transistor T7 may be connected to the initialization voltage line VL. In an embodiment, the seventh thin film transistor T7 may be turned on according to a next scan signal Sn+1 received through the next scan line SL+1, to initialize the first electrode of the light emitting diode LED.

FIG. 8 illustrates a case where the fourth thin film transistor T4 and the seventh thin film transistor T7 are respectively connected to the previous scan line SL-1 and the next scan line SL+1; however, in some embodiments, both the fourth thin film transistor T4 and the seventh thin film transistor T7 may be connected to the previous scan line SL-1 to be driven according to the previous scan signal Sn-1.

Another electrode of the storage capacitor Cst may be connected to the driving voltage line PL. The one electrode of the storage capacitor Cst may be connected to the gate electrode of the first thin film transistor T1, the drain electrode (or source electrode) of the third thin film transistor T3, and the source electrode (or drain electrode) of the fourth thin film transistor T4.

The second electrode (e.g., cathode) of the light emitting diode LED may be provided with the second power voltage ELVSS. The light emitting diode LED may emit light by receiving a driving current from the first thin film transistor T1.

In an embodiment, the light emitting diode LED may be an organic light emitting diode including an organic material as a light emitting material. In some embodiments, the light emitting diode LED may be an inorganic light emitting diode including an inorganic material. The inorganic light emitting diode may include a PN junction diode including inorganic semiconductor-based materials. When a forward voltage is applied to the PN junction diode, holes and electrons may be injected thereinto and energy generated by the recombination of the holes and electrons may be converted into light energy to emit light of a certain color. The inorganic light emitting diode described above may have a width of several to several hundred micrometers or several to several hundred nanometers. In some embodiments, the light emitting diode LED may include a quantum dot light emitting diode. As described above, an emission layer of the light emitting diode LED may include an organic material, may include an inorganic material, may include quantum dots, may include an organic material and quantum dots, or may include an inorganic material and quantum dots. Hereinafter, for convenience of description, a case where the light emitting diode LED includes an organic light emitting diode will be described as an example.

FIG. 8 illustrates that the subpixel circuit PC includes seven thin film transistors T1, T2, T3, T4, T5, T6, and T7 and one capacitor Cst; however, in some embodiments, the subpixel circuit PC may include two or more transistors and two or more capacitors. Also, the circuit design of the subpixel circuit PC is not necessarily limited to the illustration in FIG. 8 and may be variously modified.

The first to seventh thin film transistors T1, T2, T3, T4, T5, T6, and T7 may be various types of transistors. In an embodiment, as illustrated in FIG. 8, all of the first to seventh thin film transistors T1, T2, T3, T4, T5, T6, and T7 may be p-channel MOSFET (PMOS). In some embodiments, at least one of the first to seventh thin film transistors T1, T2, T3, T4, T5, T6, and T7 may be P-channel MOSFET (PMOS), and the others may be N-channel MOSFET (NMOS). In some embodiments, all of the first to seventh thin film transistors T1, T2, T3, T4, T5, T6, and T7 may be NMOS. The positions of source electrodes and drain electrodes may be interchanged with each other depending on the types (P-type or N-type) of transistors.

All of the first to seventh thin film transistors T1, T2, T3, T4, T5, T6, and T7 illustrated in FIG. 8 may be transistors including a low-temperature polysilicon semiconductor layer. In embodiments of the present disclosure, the first to seventh thin film transistors T1, T2, T3, T4, T5, T6, and T7 are not necessarily limited thereto, and at least one of the first to seventh thin film transistors T1, T2, T3, T4, T5, T6, and T7 may be a transistor including a low-temperature polycrystalline silicon (LTPS) semiconductor layer and the others may be transistors including an oxide semiconductor layer. Alternatively, all of the first to seventh thin film transistors T1, T2, T3, T4, T5, T6, and T7 may be transistors including an oxide semiconductor layer.

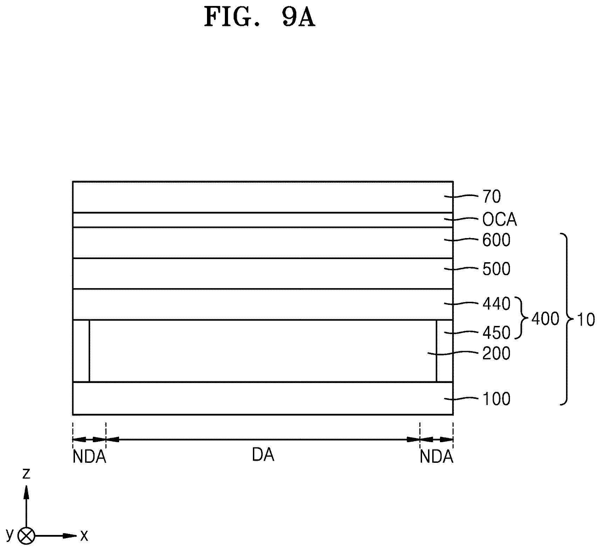

FIGS. 9A to 9D are cross-sectional views schematically illustrating a portion of the display apparatus illustrated in FIG. 6.

Referring to FIGS. 9A to 9D, the display apparatus may include a display panel 10 including a substrate 100, a display layer 200, an encapsulation member 400, a touch sensor layer 500, and an anti-reflection layer 600, an adhesive layer OCA, and a cover member 70. The cover member 70 may correspond to the cover window 70 illustrated in FIG. 6.

The substrate 100 may include glass or polymer resin. For example, in an embodiment the polymer resin may include polyether sulfone, polyacrylate, polyether imide, polyethylene naphthalate, polyethylene terephthalate, polyphenylene sulfide, polyarylate, polyimide, polycarbonate, and/or cellulose acetate propionate. The substrate 100 including the polymer resin may be flexible, rollable, or bendable. In an embodiment, the substrate 100 may have a multilayer structure including an inorganic layer and a layer including the polymer resin.

The display layer 200 may include a light emitting diode, for example, an organic light emitting diode, a thin film transistor electrically connected thereto, and insulating layers arranged therebetween.

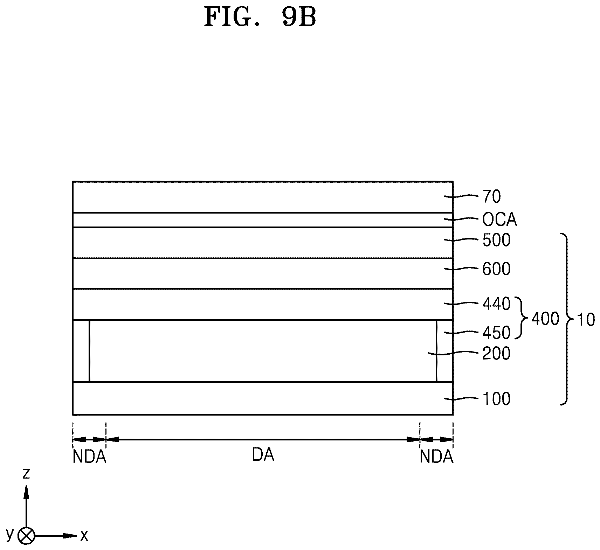

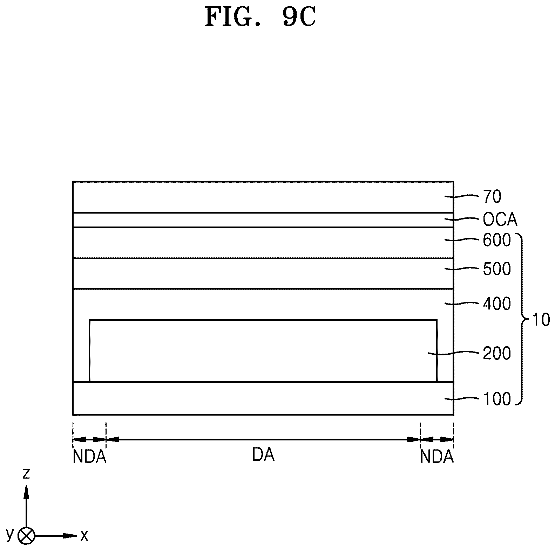

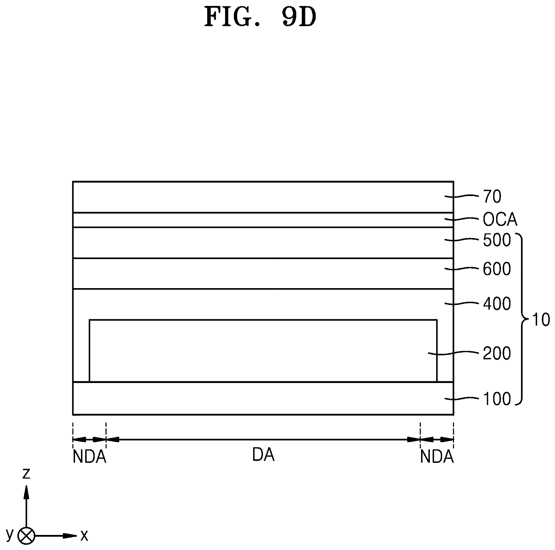

The encapsulation member 400 may be arranged over the display layer 200 (e.g., in the z direction) and may shield the display layer 200 (e.g., from moisture and/or contaminants). The encapsulation member 400 may be coupled to the substrate 100. For example, the display layer 200 may be encapsulated by the encapsulation member 400. In an embodiment, as illustrated in FIGS. 9A and 9B, the encapsulation member 400 may include an encapsulation substrate 440 including a glass material and a sealing portion 450 arranged between the encapsulation substrate 440 and the substrate 100. The encapsulation substrate 440 may be arranged over the display layer 200, and the display layer 200 may be arranged between the substrate 100 and the encapsulation substrate 440 (e.g., in the z direction). In an embodiment, a gap may be between the encapsulation substrate 440 and the display layer 200, and the gap may be filled with a filler. In some embodiments, as illustrated in FIGS. 9C and 9D, the encapsulation member 400 may include an encapsulation layer including at least one inorganic encapsulation layer and at least one organic encapsulation layer. In some embodiments, a low-reflective layer may be arranged over the display layer 200 (e.g., in the z direction), and the encapsulation member 400 may be arranged over the low-reflective layer (e.g., in the z direction).

The anti-reflection layer 600 or the touch sensor layer 500 may be arranged over the encapsulation member 400 (e.g., in the z direction). The touch sensor layer 500 may be referred to as an input sensing layer. In an embodiment, the touch sensor layer 500 may be configured to sense an external input, for example, a touch of an object such as a finger or a stylus pen, such that the display apparatus may obtain coordinate information corresponding to a touch position. The touch sensor layer 500 may include a touch electrode and trace lines connected to the touch electrode. The touch sensor layer 500 may be configured to sense an external input by a mutual cap method or a self cap method.

In an embodiment, as illustrated in FIGS. 9A and 9C, the touch sensor layer 500 may be directly formed over the encapsulation member 400 (e.g., in the z direction). Alternatively, the touch sensor layer 500 may be separately formed and then adhered onto the encapsulation member 400 through an adhesive layer such as optically clear adhesive layer. In some embodiments, as illustrated in FIGS. 9B and 9D, the touch sensor layer 500 may be directly formed over the anti-reflection layer 600 or may be separately formed and then adhered to the anti-reflection layer 600 through an adhesive layer such as an optically transparent adhesive layer.

The anti-reflection layer 600 may reduce the reflectance of external light incident from the outside (e.g., the external environment) through the cover member 70 towards the display apparatus.

In an embodiment, the anti-reflection layer 600 may include a light-blocking layer and color filters. The color filters may be arranged considering (e.g., corresponding to) the color of light emitted from each of the light emitting diodes of the display layer 200.

In the case where the anti-reflection layer 600 is included as described above, the display panel 10 may not include a separate external light polarization layer. For example, the display panel 10 may include an external light polarization layer arranged to increase the visibility of an image being implemented. However, through the anti-reflection layer 600, the display panel 10 according to embodiments may increase the front transmittance that is the ratio of light transmitted through the front of the display layer 200 to light generated in the display layer 200. Thus, the display panel 10 according to embodiments may not have to include a separate external light polarization layer to increase the visibility of an image implemented in the display layer 200. Accordingly, the display panel 10 according to embodiments may reduce the thickness and provide a clear image.

The cover member 70 may be arranged over the touch sensor layer 500 or the anti-reflection layer 600 (e.g., in the z direction). The cover member 70 may protect the layers being covered. The cover member 70 may be separately formed and then attached to the touch sensor layer 500 or the anti-reflection layer 600 by the adhesive layer OCA arranged between the cover member 70 and the touch sensor layer 500 or the anti-reflection layer 600. The adhesive layer OCA may include, for example, an optically clear adhesive. Alternatively, the cover member 70 may be directly formed over the touch sensor layer 500 or the anti-reflection layer 600.

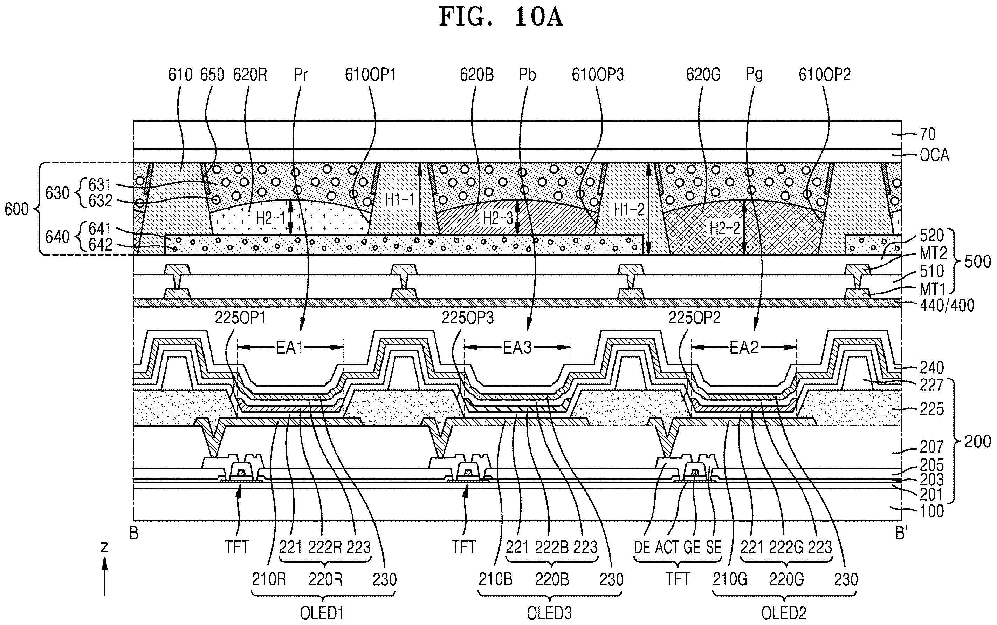

FIGS. 10A to 10D are cross-sectional views schematically illustrating a portion of a display apparatus according to embodiments. In this case, FIGS. 10A to 10D may correspond to a cross-sectional view of the display panel taken along line B-B' of FIG. 7.

Referring to FIGS. 10A to 10D, in an embodiment the display apparatus may include a display panel including a substrate 100, a display layer 200, an encapsulation member 400, a touch sensor layer 500, and an anti-reflection layer 600, an adhesive layer OCA, and a cover member 70 (e.g., stacked in the z direction).

The display apparatus may include a plurality of subpixels arranged in the display area DA (see FIG. 7). In an embodiment, each of the plurality of subpixels may emit red, green, or blue light. In an embodiment, the plurality of subpixels may include subpixels emitting light of different colors from each other, for example, a first subpixel, a second subpixel, and a third subpixel. The first subpixel may be provided as a plurality of first subpixels, the second subpixel may be provided as a plurality of second subpixels, and the third subpixel may be provided as a plurality of third subpixels. In an embodiment, the first subpixel may be a red subpixel Pr capable of emitting red light, the second subpixel may be a green subpixel Pg capable of emitting green light, and the third subpixel may be a blue subpixel Pb capable of emitting blue light.

The display layer 200 may be arranged over the substrate 100 (e.g., in the z direction). The display layer 200 may include a subpixel circuit layer and a light emitting diode layer. The subpixel circuit layer may include a thin film transistor TFT and may include a buffer layer 201, a gate insulating layer 203, an interlayer insulating layer 205, and a planarization layer 207 that are insulating layers.

The buffer layer 201 may be located over the substrate 100 to reduce or block the penetration of foreign materials, moisture, or external air from under the substrate 100 and may provide a flat surface over the substrate 100. In an embodiment, the buffer layer 201 may include an inorganic material such as oxide or nitride, an organic material, or an organic/inorganic composite and may include a single-layer or multiple-layer structure of an inorganic material and an organic material. In an embodiment, a barrier layer for blocking the penetration of external air may be further included between the substrate 100 and the buffer layer 201 (e.g., in the z direction). For example, the buffer layer 201 may include silicon oxide or silicon nitride.

The thin film transistor TFT may be arranged over the buffer layer 201 (e.g., disposed directly thereon in the z direction). The thin film transistor TFT may include a semiconductor layer ACT, a gate electrode GE, a source electrode SE, and a drain electrode DE. In an embodiment, the thin film transistor TFT may be connected to an organic light emitting diode to drive the organic light emitting diode.

The semiconductor layer ACT may be arranged over the buffer layer 201 (e.g., disposed directly thereon in the z direction). The semiconductor layer ACT may include polysilicon or amorphous silicon. Alternatively, the semiconductor layer ACT may include an oxide of at least one of indium (In), gallium (Ga), stannum (Sn), zirconium (Zr), vanadium (V), hafnium (Hf), cadmium (Cd), germanium (Ge), chromium (Cr), titanium (Ti), and zinc (Zn). The semiconductor layer ACT may include a channel area, and a source area and a drain area that are doped with dopants.

The gate electrode GE, the source electrode SE, and the drain electrode DE may be formed of various conductive materials. In an embodiment, the gate electrode GE may include at least one of molybdenum (Mo), aluminum (Al), copper (Cu), and titanium (Ti). For example, the gate electrode GE may include a single molybdenum (Mo) layer or may include a three-layer structure including a molybdenum (Mo) layer, an aluminum (Al) layer, and a molybdenum (Mo) layer. In an embodiment, the source electrode SE and the drain electrode DE may include at least one of copper (Cu), titanium (Ti), and aluminum (Al). For example, the source electrode SE and the drain electrode DE may include a three-layer structure including a titanium (Ti) layer, an aluminum (Al) layer, and a titanium (Ti) layer.

To secure the insulation between the semiconductor layer ACT and the gate electrode GE, the gate insulating layer 203 may be arranged between the semiconductor layer ACT and the gate electrode GE (e.g., in the z direction). The interlayer insulating layer 205 may be arranged over (e.g., directly thereon) the gate electrode GE, and the source electrode SE and the drain electrode DE may be arranged over the interlayer insulating layer 205 (e.g., disposed directly thereon in the z direction).

Each of the gate insulating layer 203 and the interlayer insulating layer 205 may include an inorganic material such as silicon oxide, silicon nitride, and/or silicon oxynitride. In an embodiment, the gate insulating layer 203 and the interlayer insulating layer 205 may be formed through, for example, chemical vapor deposition (CVD) or atomic layer deposition (ALD).

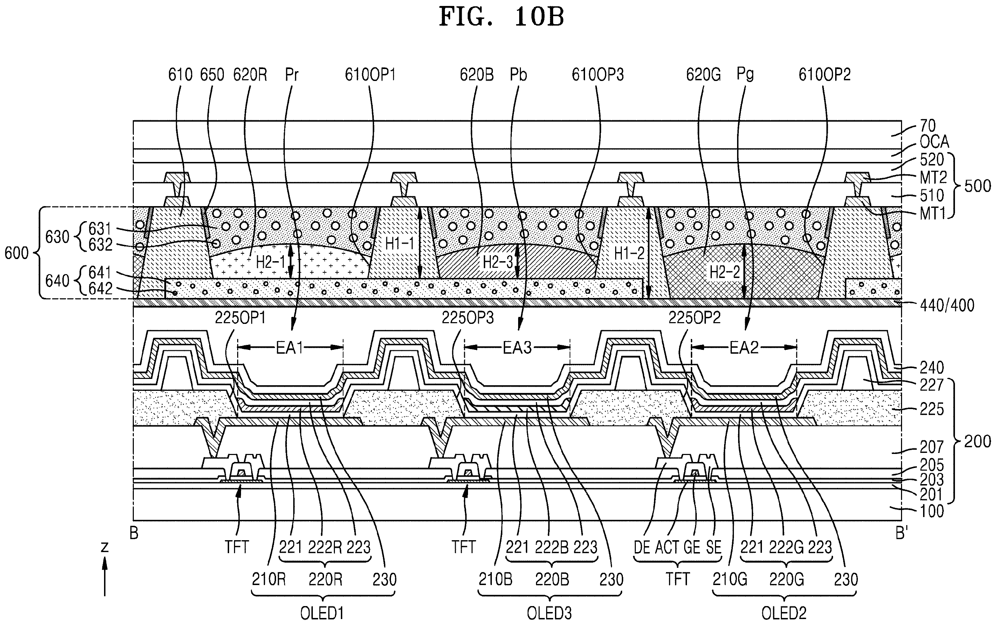

The planarization layer 207 may be arranged over (e.g., disposed directly thereon) the thin film transistor TFT. In an embodiment, to provide a flat upper surface, chemical mechanical polishing may be performed on the upper surface of the planarization layer 207 after the planarization layer 207 is formed. In an embodiment, the planarization layer 207 may include a general-purpose polymer such as polyimide, polystyrene (PS), polycarbonate (PC), benzocyclobutene (BCB), hexamethyldisiloxane (HMDSO), or polymethylmethacrylate (PMMA), photosensitive polyimide, a polymer derivative having a phenolic group, an acrylic polymer, an imide-based polymer, an aryl ether-based polymer, an amide-based polymer, a fluorine-based polymer, a p-xylene-based polymer, or a vinyl alcohol-based polymer. FIG. 10B illustrates that the planarization layer 207 includes a single layer; however, in some embodiments, the planarization layer 207 may include multiple layers. In an embodiment, each of subpixel electrodes 210R, 210G, and 210B of first to third organic light emitting diodes OLED1, OLED2, and OLED3 that are a first display element, a second display element, and a third display element, respectively, may be electrically connected to the thin film transistor TFT through a contact hole of the planarization layer 207. In this case, the first organic light emitting diode OLED1 or the second organic light emitting diode OLED2 may be a first display element or a second display element that will be described below.

The light emitting diode layer may be arranged over the subpixel circuit layer. In an embodiment, the light emitting diode layer may include first to third organic light emitting diodes OLED1, OLED2, and OLED3, a bank layer 225, and a spacer 227.

The first to third organic light emitting diodes OLED1, OLED2, and OLED3 may be arranged over the subpixel circuit layer. In an embodiment, the first organic light emitting diode OLED1 may include a stack structure of a subpixel electrode 210R, an intermediate layer 220R including a first common layer 221, an emission layer 222R, and a second common layer 223, and an opposite electrode 230, the second organic light emitting diode OLED2 may include a stack structure of a subpixel electrode 210G, an intermediate layer 220G including a first common layer 221, an emission layer 222G, and a second common layer 223, and an opposite electrode 230, and the third organic light emitting diode OLED3 may include a stack structure of a subpixel electrode 210B, an intermediate layer 220B including a first common layer 221, an emission layer 222B, and a second common layer 223, and an opposite electrode 230.

The subpixel electrodes 210R, 210G, and 210B may be arranged over the planarization layer 207. The subpixel electrodes 210R, 210G, and 210B may be arranged to be spaced apart from each other (e.g., in a plan view).

The subpixel electrodes 210R, 210G, and 210B may be reflective electrodes. In an embodiment, the subpixel electrodes 210R, 210G, and 210B may include a reflective layer including silver (Ag), magnesium (Mg), aluminum (Al), platinum (Pt), palladium (Pd), gold (Au), nickel (Ni), neodymium (Nd), iridium (Ir), chromium (Cr), or any compound thereof, and a transparent or semitransparent conductive layer formed over the reflective layer. The transparent or semitransparent conductive layer may include at least one of indium tin oxide (ITO), indium zinc oxide (IZO), zinc oxide (ZnO), indium oxide (In₂O₃), indium gallium oxide (IGO), and aluminum zinc oxide (AZO).

The bank layer 225 may be arranged over the subpixel electrodes 210R, 210G, and 210B. In an embodiment, the bank layer 225 may include first to third lower opening portions 225OP1, 225OP2, and 2225OP3 respectively overlapping the subpixel electrodes 210R, 210G, and 210B and respectively exposing center portions of the subpixel electrodes 210R, 210G, and 210B. In an embodiment, the bank layer 225 may cover the edge (e.g., lateral ends) of the subpixel electrodes 210R, 210G, and 210B and increase the distance between the edge of the subpixel electrodes 210R, 210G, and 210B and the opposite electrode 230 to prevent an arc or the like from occurring at the edge of the subpixel electrodes 210R, 210G, and 210B.

The first to third lower opening portions 225OP1, 225OP2, and 225OP3 of the bank layer 225 may define first to third emission areas EA1, EA2, and EA3 of the first to third organic light emitting diodes OLED1, OLED2, and OLED3 included in the respective subpixels. As illustrated in FIGS. 10A-10B, the bank layer 225 may include the first lower opening portion 225OP1 defining the first emission area EA1 of the first organic light emitting diode OLED1 of the first subpixel. Also, the bank layer 225 may include the second lower opening portion 225OP2 defining the second emission area EA2 of the second organic light emitting diode OLED2 of the second subpixel and the third lower opening portion 225OP3 defining the third emission area EA3 of the third organic light emitting diode OLED3 of the third subpixel.

The bank layer 225 may include an organic insulating material. Alternatively, the bank layer 225 may include an inorganic insulating material such as silicon nitride or silicon oxide. In some embodiments, the bank layer 225 may include an organic insulating material and an inorganic insulating material.

In an embodiment, the bank layer 225 may include a light-blocking material. For example, the light-blocking material of the bank layer 225 may be black. In an embodiment, the light-blocking material may include a resin or paste including carbon black, carbon nanotube, or black dye, metal (e.g., nickel, aluminum, molybdenum, or any alloy thereof) particles, metal oxide particles, or metal nitride particles. When the bank layer 225 includes a light-blocking material, the reflection of external light by metal structures arranged under the bank layer 225 may be reduced.

The spacer 227 may be arranged over the bank layer 225 (e.g., disposed directly thereon in the z direction). The spacer 227 may include an organic insulating material such as polyimide. Alternatively, the spacer 227 may include an inorganic insulating material such as silicon nitride or silicon oxide or may include an organic insulating material and an inorganic insulating material. In an embodiment, the spacer 227 may include a different material than the bank layer 225 including the above light-blocking material and may be formed in a separate process from the bank layer 225.

However, embodiments of the present disclosure are not necessarily limited thereto. For example, in some embodiments, the spacer 227 may include the same material as the bank layer 225. In this case, the bank layer 225 and the spacer 227 may be formed together in a mask process using a halftone mask.

An intermediate layer may be arranged over the subpixel electrodes 210R, 210G, and 210B and the bank layer 225. As described above, the intermediate layer may include a first common layer 221, an emission layer, and a second common layer 223.

The emission layers 222R, 222G, and 222B may be arranged in the first to third lower opening portions 225OP1, 225OP2, and 225OP3 of the bank layer 225, respectively. In an embodiment, the emission layers 222R, 222G, and 222B may include an organic material including a fluorescent or phosphorescent material capable of emitting red, green, or blue light. The above organic material may include a low-molecular weight organic material or a highmolecular weight organic material.

The first common layer 221 and the second common layer 223 may be respectively arranged under and over the emission layer (e.g., in the z direction and -z direction). The first common layer 221 may include, for example, a hole transport layer (HTL) or may include an HTL and a hole injection layer (HIL). The second common layer 223 may include, for example, an electron transport layer (ETL) or may include an ETL and an electron injection layer (EIL). In an embodiment, the second common layer 223 may be omitted.

In an embodiment, the emission layer may be arranged in each subpixel to correspond to the first to third lower opening portions 225OP1, 225OP2, and 225OP3 of the bank layer 225, whereas each of the first common layer 221 and the second common layer 223 may be integrally formed to entirely cover the substrate 100. In other words, each of the first common layer 221 and the second common layer 223 may be integrally formed to entirely cover (e.g., be commonly disposed over) the display area DA of the substrate 100.

The opposite electrode 230 may be a cathode that is an electron injection electrode. The opposite electrode 230 may include a conductive material having a low work function. For example, in an embodiment the opposite electrode 230 may include a (semi)transparent layer including silver (Ag), magnesium (Mg), aluminum (Al), platinum (Pt), palladium (Pd), gold (Au), nickel (Ni), neodymium (Nd), iridium (Ir), chromium (Cr), lithium (Li), calcium (Ca), or any alloy thereof. Alternatively, the opposite electrode 230 may further include a layer such as ITO, IZO, ZnO, or In₂O₃ over the (semi)transparent layer including the above material.

In an embodiment, a capping layer 240 may be further arranged over the display layer 200 (e.g., disposed directly thereon in the z direction). The capping layer 240 may be arranged over the first to third organic light emitting diodes OLED1, OLED2, and OLED3. In an embodiment, the capping layer 240 may increase the light emission efficiency of the first to third organic light emitting diodes OLED1, OLED2, and OLED3 by the principle of constructive interference.

The capping layer 240 may be an organic capping layer including an organic material, an inorganic capping layer including an inorganic material, or a composite capping layer including an organic material and an inorganic material. For example, in an embodiment the capping layer 240 may include a carbocyclic compound, a heterocyclic compound, an amine group-containing compound, a porphine derivative, a phthalocyanine derivative, a naphthalocyanine derivative, an alkali metal complex, an alkaline earth metal complex, or any combination thereof. The carbocyclic compound, the heterocyclic compound, and the amine group-containing compound may be selectively substituted with a substituent including O, N, S, Se, Si, F, Cl, Br, I, or any combination thereof.

An encapsulation member 400 may be arranged over the capping layer 240 described above. For example, in an embodiment, as illustrated in FIGS. 10A and 10B, an encapsulation substrate 440 may be arranged over the capping layer 240 to be spaced apart from the capping layer 240 (e.g., in the z direction). In this case, the encapsulation substrate 440 may be connected to the substrate 100 through the sealing portion 450 (see FIG. 9A and FIG. 9B).

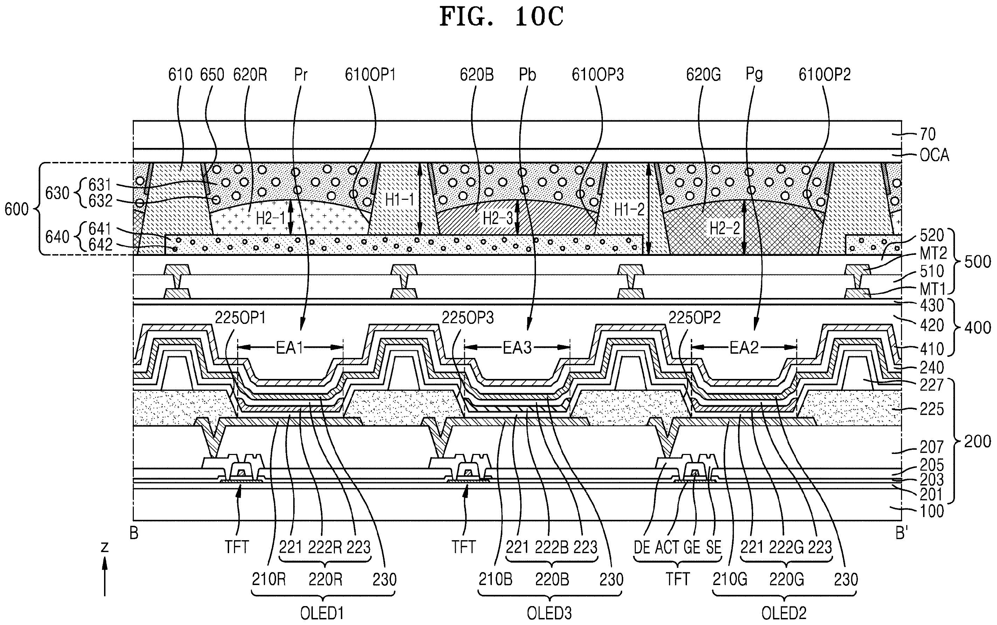

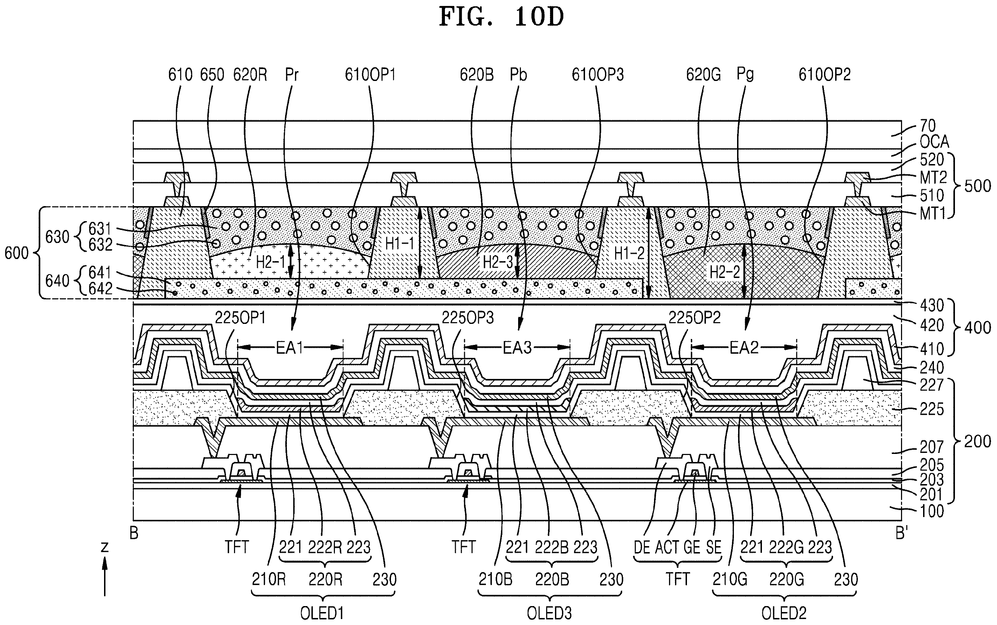

In an embodiment, as illustrated in FIGS. 10C and 10D, an encapsulation layer that is the encapsulation member 400 may be arranged over the capping layer 240 (e.g., disposed directly thereon in the z direction). The encapsulation layer may include at least one inorganic encapsulation layer and at least one organic encapsulation layer. For example, as illustrated in an embodiment shown in FIG. 10C, the encapsulation layer may include a first inorganic encapsulation layer 410, an organic encapsulation layer 420, and a second inorganic encapsulation layer 430 that are sequentially stacked (e.g., in the z direction).

In an embodiment, the first inorganic encapsulation layer 410 and the second inorganic encapsulation layer 430 may include an inorganic insulating material such as silicon oxide, silicon nitride, silicon oxynitride, aluminum oxide, titanium oxide, tantalum oxide, hafnium oxide, or zinc oxide. The first inorganic encapsulation layer 410 and the second inorganic encapsulation layer 430 may have a single-layer or multiple-layer structure including the above inorganic insulating material.

The organic encapsulation layer 420 may relieve the internal stress of the first inorganic encapsulation layer 410 and/or the second inorganic encapsulation layer 430. The organic encapsulation layer 420 may include a polymer-based material. For example, in an embodiment the organic encapsulation layer 420 may include polyethyleneterephthalate, polyethylenenaphthalate, polycarbonate, polyimide, polyethylenesulfonate, polyoxymethylene, polyarylate, hexamethyldisiloxane, acryl-based resin (e.g., polymethylmethacrylate or polyacrylic acid), or any combination thereof.

The encapsulation layer may have a multilayer structure of the first inorganic encapsulation layer 410, the organic encapsulation layer 420, and the second inorganic encapsulation layer 430. In this case, even when a crack occurs in the encapsulation layer, the crack may not propagate between the first inorganic encapsulation layer 410 and the organic encapsulation layer 420 or between the organic encapsulation layer 420 and the second inorganic encapsulation layer 430. The encapsulation layer may prevent or minimize the penetration of external moisture or oxygen into the display area DA.

The touch sensor layer 500 may be arranged over the encapsulation member 400(e.g., in the z direction) as illustrated in FIG. 10A or 10C or may be arranged over the anti-reflection layer 600 (e.g., in the z direction) as illustrated in FIG. 10B or 10D. When the touch sensor layer 500 is arranged over the encapsulation member 400, the touch sensor layer 500 may be arranged over the encapsulation substrate 440 (e.g., in the z direction) as illustrated in FIG. 10A or be arranged over the encapsulation layer as illustrated in FIG. 10C (e.g. in the z direction).

In an embodiment, the touch sensor layer 500 may include a first touch electrode MT1, a first touch insulating layer 510, a second touch electrode MT2, and a second touch insulating layer 520. The first touch electrode MT1 may be arranged over the encapsulation member 400. For example, the first touch electrode MT1 may be directly arranged over the encapsulation substrate 440 (e.g., in the z direction) as illustrated in FIG. 10A, over the anti-reflection layer 600 (e.g., in the z direction) as illustrated in FIG. 10B or 10D, or over the second inorganic encapsulation layer 430 of the encapsulation layer (e.g., in the z direction) as illustrated in FIG. 10C. However, embodiments of the present disclosure are not necessarily limited thereto.

In an embodiment, the touch sensor layer 500 may include an insulating layer arranged between the first touch electrode MT1 and the encapsulation layer (e.g., in the z direction), between the first touch electrode MT1 and the encapsulation substrate 440 (e.g., in the z direction), or between the first touch electrode MT1 and the anti-reflection layer 600 (e.g., in the z direction). In this case, the insulating layer may be arranged over the second inorganic encapsulation layer 430, the encapsulation substrate 440, or the anti-reflection layer 600 to planarize a surface on which the first touch electrode MT1 and the like are arranged. In an embodiment, the insulating layer may include an inorganic insulating material such as silicon oxide, silicon nitride, or silicon oxynitride. In some embodiments, the insulating layer may include an organic insulating material.

The first touch insulating layer 510 may be arranged over (e.g., disposed directly thereon) the first touch electrode MT1. The first touch insulating layer 510 may include an inorganic material or an organic material. In an embodiment in which the first touch insulating layer 510 includes an inorganic material, the first touch insulating layer 510 may include at least one of silicon nitride, aluminum nitride, zirconium nitride, titanium nitride, hafnium nitride, tantalum nitride, silicon oxide, aluminum oxide, titanium oxide, tin oxide, cerium oxide, and silicon oxynitride. In an embodiment in which the first touch insulating layer 510 includes an organic material, the first touch insulating layer 510 may include at least one of acryl-based resin, methacryl-based resin, polyisoprene, vinyl-based resin, epoxy-based resin, urethane-based resin, cellulose-based resin, and perylene-based resin.

The second touch electrode MT2 may be arranged over the first touch insulating layer 510 (e.g., disposed directly thereon in the z direction). The second touch electrode MT2 may function as a sensor for sensing a user's touch input. The first touch electrode MT1 may function as a connector for connecting the second touch electrode MT2 patterned, in one direction. In an embodiment, both the first touch electrode MT1 and the second touch electrode MT2 may function as a sensor. In this case, the first touch electrode MT1 and the second touch electrode MT2 may be electrically connected through a contact hole. When both the first touch electrode MT1 and the second touch electrode MT2 function as a sensor, the resistance of the touch electrodes may decrease and thus a user's touch input may be rapidly sensed.

In an embodiment, the first touch electrode MT1 and the second touch electrode MT2 may have a structure through which light emitted from the organic light emitting diode OLED1, OLED2, or OLED3 may pass, for example, a mesh structure. In this case, the first touch electrode MT1 and the second touch electrode MT2 may be arranged not to overlap the emission area EA1, EA2, or EA3 of the organic light emitting diode OLED1, OLED2, or OLED3 (e.g., in the z direction).

The first touch electrode MT1 and the second touch electrode MT2 may include a metal layer or a transparent conductive layer. In an embodiment, the metal layer may include molybdenum (Mo), silver (Ag), titanium (Ti), copper (Cu), aluminum (Al), and/or any alloy thereof. The transparent conductive layer may include a transparent conductive oxide such as indium tin oxide (ITO), indium zinc oxide (IZO), zinc oxide (ZnO), or indium tin zinc oxide (ITZO), a conductive polymer such as PEDOT, a metal nanowire, a carbon nanotube, or graphene.

The second touch insulating layer 520 may be arranged over (e.g., directly thereon) the second touch electrode MT2. The second touch insulating layer 520 may include an inorganic material or an organic material. In an embodiment in which the second touch insulating layer 520 includes an inorganic material, the second touch insulating layer 520 may include at least one of silicon nitride, aluminum nitride, zirconium nitride, titanium nitride, hafnium nitride, tantalum nitride, silicon oxide, aluminum oxide, titanium oxide, tin oxide, cerium oxide, and silicon oxynitride. In an embodiment in which the second touch insulating layer 520 includes an organic material, the second touch insulating layer 520 may include at least one of acryl-based resin, methacryl-based resin, polyisoprene-based resin, vinyl-based resin, epoxy-based resin, urethane-based resin, cellulose-based resin, and perylene-based resin.

In some embodiments, the touch sensor layer 500 may include the first touch electrode MT1, the first touch insulating layer 510, and the second touch electrode MT2 and may not include the second touch insulating layer 520. In this embodiment, the anti-reflection layer 600 may be provided to cover the second touch electrode MT2.

As illustrated in FIG. 10D, the anti-reflection layer 600 may be arranged over the encapsulation layer (e.g., in the z direction). In an embodiment, the anti-reflection layer 600 may be arranged over the encapsulation substrate 440 (e.g., disposed directly thereon in the z direction) illustrated in FIG. 10B. In an embodiment, the anti-reflection layer 600 may be arranged over the touch sensor layer 500 as illustrated in FIGS. 10A and 10C (e.g., disposed directly thereon in the z direction) or arranged under the touch sensor layer 500 as illustrated in FIGS. 10B and 10D (e.g., disposed directly thereunder in the -z direction).

The anti-reflection layer 600 may include a first light-blocking layer 610 and a plurality of color filters. In an embodiment, the anti-reflection layer 600 may include first to third color filters 620R, 620G, and 620B of different colors from each other respectively corresponding to the first to third organic light emitting diodes OLED1, OLED2, and OLED3. In an embodiment, each of the first to third color filters 620R, 620G, and 620B may be provided as a plurality of color filters.

The first light-blocking layer 610 may include first to third upper opening portions 610OP1, 6100P2, and 610OP3 respectively corresponding to (e.g., overlapping in the z direction) the first to third subpixels. The first light-blocking layer 610 may include the first upper opening portion 610OP1 corresponding to the first emission area EA1, the second upper opening portion 610OP2 corresponding to the second emission area EA2, and the third upper opening portion 610OP3 corresponding to the third emission area EA3. For example, the first to third upper opening portions 610OP1, 6100P2, and 610OP3 may overlap the first to third emission areas EA1 to EA3 (e.g., in the z direction) respectively. Light emitted from the first to third organic light emitting diodes OLED1, OLED2, and OLED3 may be emitted to the outside (e.g., the external environment) through the first to third upper opening portions 610OP1, 6100P2, and 610OP3 of the first light-blocking layer 610.

The first upper opening portion 610OP1 of the first light-blocking layer 610 may overlap the first lower opening portion 225OP1 of the bank layer 225 (e.g., in the z direction), the second upper opening portion 610OP2 may overlap the second lower opening portion 225OP2 (e.g., in the z direction), and the third upper opening portion 610OP3 may overlap the third lower opening portion 225OP3 (e.g., in the z direction).

Herein, the width (or size) of each subpixel may refer to the width (or size) of the emission area of the organic light emitting diode implementing each subpixel, and the width (or size) of the emission area may be defined by the width (or size) of the subpixel electrode exposed by the lower opening portion included in the bank layer 225.

In an embodiment, the width (or size) of each of the first to third upper opening portions 610OP1, 6100P2, and 610OP3 of the first light-blocking layer 610 (e.g., in a plan view) may be greater than the width (or size) of a corresponding subpixel among the first to third subpixels (e.g., in a plan view). For example, the width (or size) of each of the first to third upper opening portions 610OP1, 6100P2, and 610OP3 of the first light-blocking layer 610 may be greater than the width (or size) of a corresponding lower opening portion of the first to third lower opening portions 225OP1, 225OP2, and 225OP3 of the bank layer 225.

In an embodiment, the width (or size) of each of the first to third upper opening portions 610OP1, 6100P2, and 610OP3 of the first light-blocking layer 610 (e.g., in a plan view) may be substantially equal to the width (or size) of a corresponding subpixel among the first to third subpixels (e.g., in a plan view). For example, the width (or size) of each of the first to third upper opening portions 610OP1, 610OP2, and 610OP3 of the first light-blocking layer 610 may be substantially equal to the width (or size) of a corresponding lower opening portion of the first to third lower opening portions 225OP1, 225OP2, and 225OP3 of the bank layer 225.

In an embodiment, the first light-blocking layer 610 may include an organic insulating material. Alternatively, the first light-blocking layer 610 may include an inorganic insulating material such as silicon nitride or silicon oxide. In some embodiments, the first light-blocking layer 610 may include an organic insulating material and an inorganic insulating material.

In an embodiment, the first light-blocking layer 610 may include a light-blocking material. For example, the light-blocking material of the first light-blocking layer 610 may be black. The light-blocking material may include a resin or paste including carbon black, carbon nanotube, or black dye, metal (e.g., nickel, aluminum, molybdenum, or any alloy thereof) particles, metal oxide particles, or metal nitride particles. Since the first light-blocking layer 610 includes a light-blocking material, the reflection of external light by metal structures arranged thereunder may be reduced.

The first to third color filters 620R, 620G, and 620B may be respectively arranged in the first to third upper opening portions 610OP1, 6100P2, and 610OP3 of the first light-blocking layer 610 and may respectively overlap the first to third emission areas EA1 to EA3 (e.g., in the z direction). The first to third color filters 620R, 620G, and 620B may have a color corresponding to the light emitted from the first to third emission areas EA1, EA2, and EA3. In an embodiment, the first color filter 620R may be a red color filter when the first emission area EA1 emits red light, the second color filter 620G may be a green color filter when the second emission area EA2 emits green light, and the third color filter 620B may be a blue color filter when the third emission area EA3 emits blue light. In an embodiment, at least one surface of at least one of the first to third color filters 620R, 620G, and 620B may be curved (e.g., in a cross-sectional view). For example, in an embodiment the upper surfaces of at least one of the first to third color filters 620R, 620G, and 620B may be rounded (or curved). For example, each of the first to third color filters 620R, 620G, and 620B may have a center portion that is highest and may be lowered from the center portion towards the first light-blocking layer 610. For example, the upper surfaces of the first to third color filters 620R, 620G, and 620B may be convex in a direction towards the cover member 70.

The height of the first light-blocking layer 610 measured from the bottom of the first light-blocking layer 610 to the upper surface of the first light-blocking layer 610 may differ depending on the arrangement of a scattering layer 640 described below. For example, a height H1-1 (e.g., length in the z direction) of the first light-blocking layer 610 arranged over the scattering layer 640 may be less than a height H1-2 (e.g., length in the z direction) of the first light-blocking layer 610 into which a portion of the scattering layer 640 is inserted and which includes a portion that does not have the scattering layer 640. In an embodiment, the height of the first light-blocking layer 610 may be equal throughout the entire display area DA. In this case, when the lower surface and upper surface of the first light-blocking layer 610 are substantially smooth surfaces with a curve, the heights of the first light-blocking layer 610 may refer to the distance from the lowest point of the curve of the lower surface of the first light-blocking layer 610 to the highest point of the curve of the upper surface of the first light-blocking layer 610.

In the above case, the entire upper surface of the first light-blocking layer 610 may be arranged at the same distance from one surface of the substrate 100 throughout the entire surface of the first light-blocking layer 610, or at least two portions of the upper surface of the first light-blocking layer 610 may be arranged at different distances from one surface of the substrate 100. Hereinafter, for the convenience of description, a detailed description will be given mainly of a case where the entire upper surface of the first light-blocking layer 610 is arranged at the same distance from one surface of the substrate 100.

At least two of a first maximum height H2-1 that is the maximum height (e.g., length in the z direction) among the heights of the first color filter 620R, a second maximum height H2-2 that is the maximum height (e.g., length in the z direction) among the heights of the second color filter 620G, and a third maximum height H2-3 that is the maximum height (e.g., length in the z direction) among the heights of the third color filter 620B may be different from each other. In an embodiment, all of the first maximum height H2-1 that is the maximum height among the heights of the first color filter 620R, the second maximum height H2-2 that is the maximum height among the heights of the second color filter 620G, and the third maximum height H2-3 that is the maximum height among the heights of the third color filter 620B may be equal to each other. In the above case, the height of each of the first to third color filters 620R, 620G, and 620B may refer to the distance from the lower surface of each of the first to third color filters 620R, 620G, and 620B to the upper surface of each of the first to third color filters 620R, 620G, and 620B measured in a direction perpendicular to the lower surface of each of the first to third color filters 620R, 620G, and 620B (e.g., in the z direction). Hereinafter, for convenience of description, a detailed description will be given mainly of a case where at least two of the first maximum height H2-1 that is the maximum height among the heights of the first color filter 620R, the second maximum height H2-2 that is the maximum height among the heights of the second color filter 620G, and the third maximum height H2-3 that is the maximum height among the heights of the third color filter 620B are different from each other.

In the above case, the first maximum height H2-1, the second maximum height H2-2, and the third maximum height H2-3 may be less than or equal to the heights H1-1 and H1-2 of the portions of the first light-blocking layer 610 adjacent to each color filter. In this case, the heights H1-1 and H1-2 of the portions of the first light-blocking layer 610 may be measured in the same or similar way as the height of each of the first to third color filters 620R, 620G, and 620B. In this case, the upper surface of the first light-blocking layer 610 may be arranged at a position (e.g., a level) equal to or higher than the highest point of the first color filter 620R, the highest point of the second color filter 620G, and the highest point of the third color filter 620B. Accordingly, when each of the first to third color filters 620R, 620G, and 620B is formed by inkjet printing, mixing of each color filter with another color filter adjacent thereto may be reduced.

The anti-reflection layer 600 may further include a refractive layer 630. The refractive layer 630 may be arranged over the first light-blocking layer 610 and/or the first to third color filters 620R, 620G, and 620B. The refractive layer 630 may planarize the upper surface of the first light-blocking layer 610 and/or the first to third color filters 620R, 620G, and 620B. In an embodiment, the refractive layer 630 may include a first base layer 631 that is colorless and transparent and does not have a color in the visible light band. The first base layer 631 may include a colorless transparent organic material such as an acryl-based resin. The refractive layer 630 may include low-refractive particles 632 included in the first base layer 631. In an embodiment, the low-refractive particles 632 may include silica having a refractive index in a range of about 1.5 to about 1.6. In this case, the silica may have a space therein. The space may include air or a low-density foamed resin. For example, the low-density foamed resin may include a foamed polystyrenebased resin and/or a low-density acrylate-based resin having a refractive index in a range of about 1.3 to about 1.4. Alternatively, the low-refractive particles 632 may also include titanium dioxide. In this case, similarly to the above description, the titanium dioxide may have a space therein and the space may include air or a low-density foamed resin.

In an embodiment, the refractive index of the refractive layer 630 may have a range of about 1 to about 1.5. The refractive index of the refractive layer 630 may be the average refractive index of the first base layer 631 when the low-refractive particles 632 are arranged therein. The refractive index of the refractive layer 630 may be less than the refractive index of each color filter 620R, 620G, or 620B. For example, in an embodiment the refractive index of each color filter 620R, 620G, or 620B may be about 1.6. When the refractive index of the refractive layer 630 is less than the refractive index of each color filter 620R, 620G, or 620B, the front transmittance of the light passing through each color filter 620R, 620G, or 620B when the light emitted from each organic light emitting diode OLED1, OLED2, or OLED3 passes through each color filter 620R, 620G, or 620B may increase. For example, the front transmittance of the light passing through each color filter 620R, 620G, or 620B may increase as the difference between the refractive index of each color filter 620R, 620G, or 620B and the refractive index of the refractive layer 630 increases. Accordingly, not only the brightness of an image implemented in the display apparatus may increase, but also the clarity thereof may increase.

In an embodiment, the anti-reflection layer 600 may include a scattering layer 640. The scattering layer 640 may be arranged between the first light-blocking layer 610 and the encapsulation member 400 (e.g., in the z direction)). The scattering layer 640 may be arranged over the touch sensor layer 500 as illustrated in FIG. 10A or 10C (e.g., disposed directly thereon in the z direction). In an embodiment, the scattering layer 640 may be arranged over the encapsulation substrate 440 as illustrated in FIG. 10B (e.g., disposed directly thereon in the z direction). In an embodiment, the scattering layer 640 may also be arranged over the encapsulation layer as illustrated in FIG. 10D (e.g., disposed directly on in the z direction).

In an embodiment, the scattering layer 640 described above may include a second base layer 641 and scattering particles 642 arranged in the second base layer 641. In this case, the second base layer 641 may include an organic insulating material in which scattering particles are dispersed, such as a polyimide-based resin, an acryl-based resin, or benzocyclobutene (BCB). In an embodiment, the scattering particles 642 may include at least one of zinc oxide (ZnO), cesium oxide (CeO₂), zirconium oxide (ZrO₂), titanium dioxide (TiO₂), indium tin oxide (ITO), and antimony tin oxide (ATO). In an embodiment in which the scattering particles 642 include titanium dioxide, the titanium dioxide may be alkaline-treated. For example, a solution exceeding PH 7 may be sprayed on the surface of the titanium dioxide, or the titanium dioxide may be immersed in the solution. A plurality of scattering particles 642 may be formed in a granular form to be spaced apart from each other in the second base layer 641.

In an embodiment, the scattering layer 640 described above may be arranged to overlap at least one of the plurality of display elements (e.g., in the z direction), such as at least one of the first to third organic light emitting diodes OLED1 to OLED3. For example, in an embodiment, the scattering layer 640 may be arranged to correspond to the first organic light emitting diode OLED1 and the third organic light emitting diode OLED3. In this case, the scattering layer 640 may include an opening area to expose a portion corresponding to the second organic light emitting diode OLED2. The scattering layer 640 may scatter the light emitted from the first organic light emitting diode OLED1 and the third organic light emitting diode OLED3. Also, the scattering layer 640 may increase the brightness of the light passing through the scattering layer 640 by reflecting the light emitted from the first organic light emitting diode OLED1 and the third organic light emitting diode OLED3 multiple times in the scattering layer 640. Also, the scattering layer 640 may transmit the light passing through the scattering layer 640, in various directions.

In an embodiment, the anti-reflection layer 600 may include a water-repellent layer 650 arranged on at least a portion of the first light-blocking layer 610. For example, the water-repellent layer 650 may be arranged over (e.g., arranged on at least one exterior surface of) the first light-blocking layer 610. The water-repellent layer 650 may be arranged on the upper surface of the first light-blocking layer 610 and/or on the upper side surface of the first light-blocking layer 610. In an embodiment, the water-repellent layer 650 may include a fluorine-based liquid-repellent agent, a silicon-based liquid-repellent agent, and/or an alkyl-based liquid-repellent agent. The water-repellent layer 650 described above may allow ink, which is used to form each color filter 620R, 620G, or 620B when manufacturing each color filter 620R, 620G, or 620B by inkjet printing, to be accurately located in the first to third upper opening portions 610OP1, 610OP2, and 610OP3 that are first opening portions included in the first light-blocking layer 610.

The cover member 70 may be arranged over the touch sensor layer 500 or the anti-reflection layer 600 with the adhesive layer OCA therebetween (e.g., in the z direction).

In the above case, the display apparatus may implement a clear image and increase the front transmittance of the light passing through the first to third color filters 620R, 620G, and 620B.

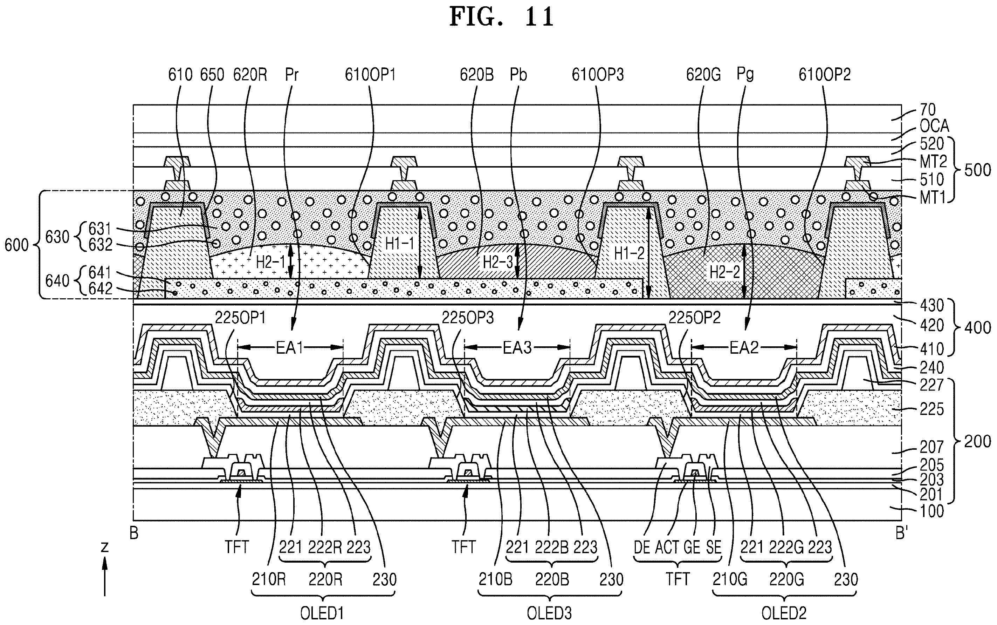

FIG. 11 is a cross-sectional view schematically illustrating a portion of a display apparatus according to embodiments. In FIG. 11, the same reference numerals as those in FIGS. 10A to 10D may denote the same members as those in FIGS. 10A to 10D. Hereinafter, differences from FIGS. 10A to 10D will be mainly described in detail for economy of explanation.

Referring to FIG. 11, in an embodiment the display apparatus may include a substrate 100, a display layer 200, an encapsulation member 400, an anti-reflection layer 600, a touch sensor layer 500, an adhesive layer OCA, and a cover member 70. In this case, the substrate 100, the display layer 200, the encapsulation member 400, the touch sensor layer 500, the adhesive layer OCA, and the cover member 70 may be the same as or similar to those described above with reference to FIGS. 10C and 10D, and thus, redundant descriptions thereof will be omitted for conciseness purposes.

The anti-reflection layer 600 may include a first light-blocking layer 610, first to third color filters 620R, 620G, and 620B, a refractive layer 630, a scattering layer 640, and a water-repellent layer 650. In this case, the first light-blocking layer 610, the first to third color filters 620R, 620G, and 620B, the scattering layer 640 including a second base layer 641 and scattering particles 642, and the water-repellent layer 650 may be the same as or similar to those described above with reference to FIGS. 10A to 10D, and thus, redundant descriptions thereof will be omitted for conciseness purposes.

The refractive layer 630 may include a first base layer 631 and low-refractive particles 632. In this case, the first base layer 631 and the low-refractive particles 632 may be the same as or similar to those described above with reference to FIGS. 10A to 10D, and thus, redundant descriptions thereof will be omitted for conciseness purposes.

The refractive layer 630 may be arranged over the first light-blocking layer 610 and the first to third color filters 620R, 620G, and 620B (e.g., disposed directly thereon in the z direction). In this case, the refractive layer 630 may be arranged not only in the first to third upper opening portions 610OP1, 6100P2, and 610OP3 but also on the upper surface of the first light-blocking layer 610. In this case, the refractive layers 630 may be connected to each other throughout the display area DA and may be commonly disposed throughout the display area DA. In the above case, the thicknesses of the refractive layer 630 (e.g., length in the z direction) may be different from each other in the respective portions. For example, the thickness of the refractive layer 630 may be the smallest on the upper surface of the first light-blocking layer 610. Also, the thickness of the refractive layer 630 arranged in each of the first to third upper opening portions 610OP1, 610OP2, and 610OP3 may be smallest at the center of each of the first to third color filters 620R, 620G, and 620B and may increase towards both side surfaces of the first to third color filters 620R, 620G, and 620B.

In an embodiment, the display apparatus may have a similar form to that illustrated in FIG. 10A. For example, the display apparatus may include an encapsulation member including an encapsulation substrate and a sealing portion and may include the touch sensor layer 500 arranged over the encapsulation substrate. Also, the anti-reflection layer 600 may be arranged over the touch sensor layer 500. In this case, the anti-reflection layer 600 may include a refractive layer 630 in the form illustrated in FIG. 11.

In an embodiment, the display apparatus may have a similar form to that illustrated in FIG. 10B. For example, the anti-reflection layer 600 may be arranged over the encapsulation substrate, and the touch sensor layer 500 may be arranged over the anti-reflection layer 600. In this case, the anti-reflection layer 600 may include a refractive layer 630 in the form illustrated in FIG. 11.

In an embodiment, the display apparatus may have a similar form to that illustrated in FIG. 10C. For example, the touch sensor layer 500 may be arranged over the encapsulation layer, and the anti-reflection layer 600 may be arranged over the touch sensor layer 500. In this case, the anti-reflection layer 600 may include a refractive layer 630 in the form illustrated in FIG. 11.

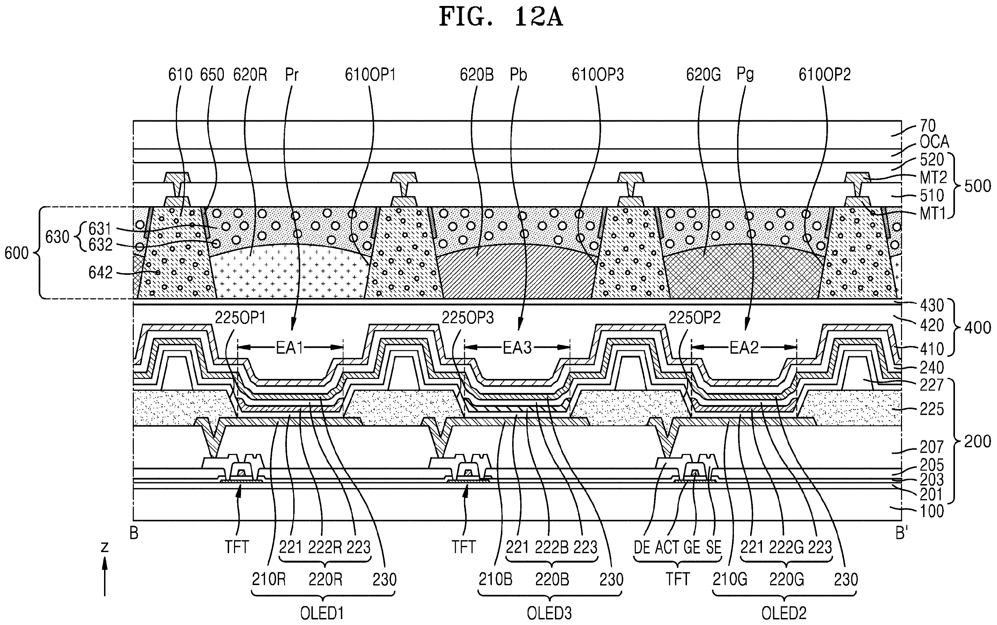

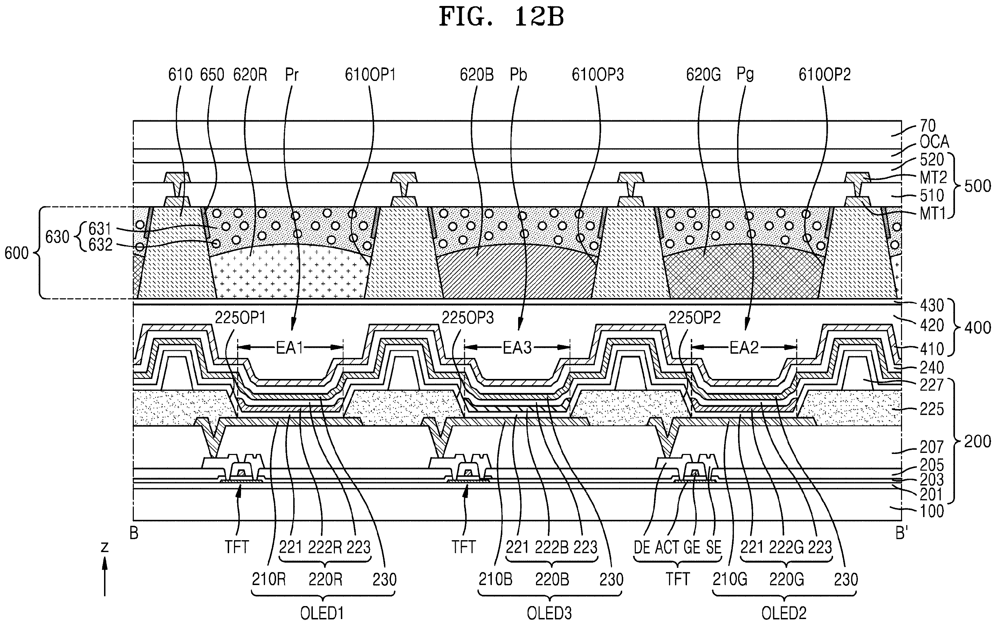

FIGS. 12A and 12B are cross-sectional views schematically illustrating a portion of a display apparatus according to embodiments. In FIGS. 12A and 12B, the same reference numerals as those in FIGS. 10A to 10D may denote the same members as those in FIGS. 10A to 10D. Hereinafter, differences from FIGS. 10A to 10D will be mainly described in detail for economy of explanation.

Referring to FIG. 12A, in an embodiment the display apparatus may include a substrate 100, a display layer 200, an encapsulation member 400, an anti-reflection layer 600, a touch sensor layer 500, an adhesive layer OCA, and a cover member 70. In this case, the substrate 100, the display layer 200, the encapsulation member 400, the touch sensor layer 500, the adhesive layer OCA, and the cover member 70 may be the same as or similar to those described above with reference to FIGS. 10C and 10D, and thus, redundant descriptions thereof will be omitted for conciseness purposes.

The anti-reflection layer 600 may include a first light-blocking layer 610, first to third color filters 620R, 620G, and 620B, a refractive layer 630, and a water-repellent layer 650. In this case, the first light-blocking layer 610, the first to third color filters 620R, 620G, and 620B, and the water-repellent layer 650 may be the same as or similar to those described above with reference to FIGS. 10A to 10D, and thus, redundant descriptions thereof will be omitted for conciseness purposes.

The refractive layer 630 may include a first base layer 631 and low-refractive particles 632. In this case, the first base layer 631 and the low-refractive particles 632 may be the same as or similar to those described above with reference to FIGS. 10A to 10D, and thus, redundant descriptions thereof will be omitted for conciseness purposes.

The refractive layer 630 may be arranged in each of the first to third upper opening portions 610OP1, 610OP2, and 610OP3. In this case, the refractive layer 630 may be the same as or similar to that described above with reference to FIGS. 10A to 10D or FIG. 11, and thus, redundant descriptions thereof will be omitted for conciseness purposes.

Referring to FIG. 12A, in an embodiment, the anti-reflection layer 600 may include scattering particles 642 arranged in at least a portion of the first light-blocking layer 610. In this case, the scattering particles 642 may be the same as or similar to those described above with reference to FIGS. 10A to 10D. When the scattering particles 642 are arranged in the first light-blocking layer 610 as described above, the light emitted from the first to third organic light emitting diodes OLED1, OLED2, and OLED3 may be scattered in the first light-blocking layer 610 and accordingly more light may be introduced into each of the first to third color filters 620R, 620G, and 620B respectively corresponding to the first to third organic light emitting diodes OLED1, OLED2, and OLED3.

Referring to FIG. 12B, in an embodiment, the anti-reflection layer 600 may not include a scattering layer or scattering particles 642 in contrast to embodiments shown in FIGS. 10A-10D.

In an embodiment, the display apparatus may have a similar form to that illustrated in FIG. 10A. For example, the display apparatus may include an encapsulation member including an encapsulation substrate and a sealing portion and may include the touch sensor layer 500 arranged over the encapsulation substrate. Also, the anti-reflection layer 600 may be arranged over the touch sensor layer 500. In this case, the anti-reflection layer 600 may be an anti-reflection layer 600 in the form illustrated in FIG. 12A or 12B.

In an embodiment, the display apparatus may have a similar form to that illustrated in FIG. 10B. For example, the anti-reflection layer 600 may be arranged over the encapsulation substrate, and the touch sensor layer 500 may be arranged over the anti-reflection layer 600. In this case, the anti-reflection layer 600 may be an anti-reflection layer 600 in the form illustrated in FIG. 12A or 12B.

In an embodiment, the display apparatus may have a similar form to that illustrated in FIG. 10C. For example, the touch sensor layer 500 may be arranged over the encapsulation layer, and the anti-reflection layer 600 may be arranged over the touch sensor layer 500. In this case, the anti-reflection layer 600 may be an anti-reflection layer 600 in the form illustrated in FIG. 12A or 12B.

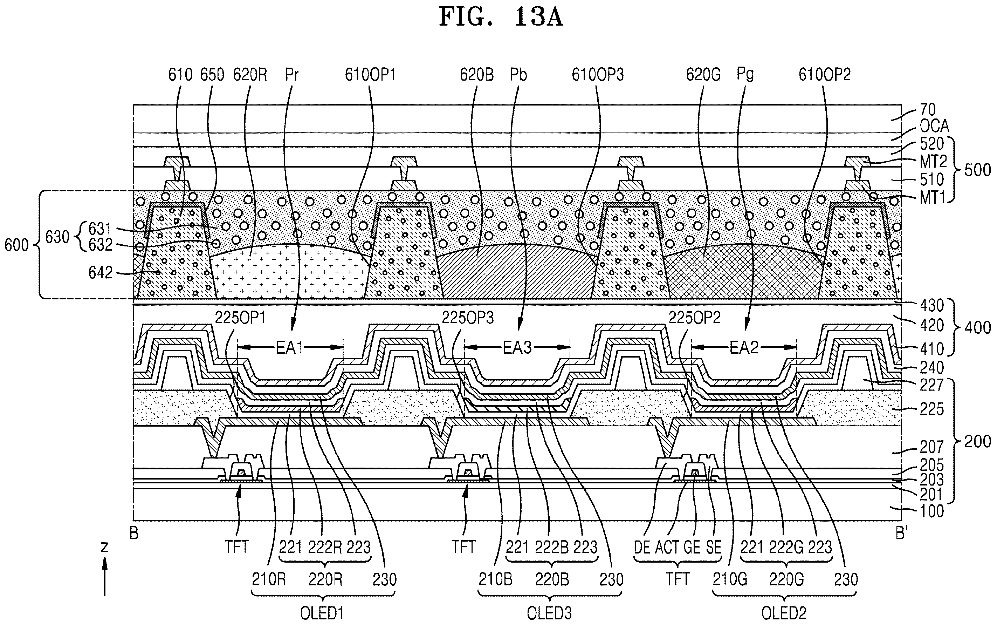

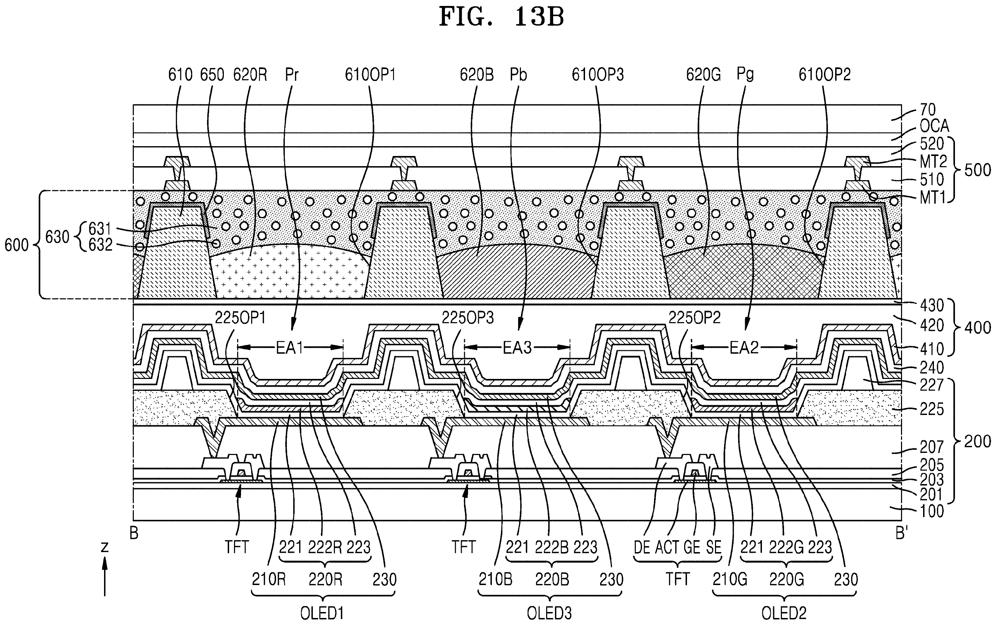

FIGS. 13A and 13B are cross-sectional views schematically illustrating a portion of a display apparatus according to embodiments. In FIGS. 13A and 13B, the same reference numerals as those in FIGS. 10A to 10D may denote the same members as those in FIGS. 10A to 10D. Hereinafter, differences from FIGS. 10A to 10D will be mainly described in detail for economy of explanation.

Referring to FIGS. 13A and 13B, in an embodiment the display apparatus may include a substrate 100, a display layer 200, an encapsulation member 400, an anti-reflection layer 600, a touch sensor layer 500, an adhesive layer OCA, and a cover member 70. In this case, the substrate 100, the display layer 200, the encapsulation member 400, the touch sensor layer 500, the adhesive layer OCA, and the cover member 70 may be the same as or similar to those described above with reference to FIGS. 10C and 10D, and thus, redundant descriptions thereof will be omitted for conciseness purposes.

The anti-reflection layer 600 may include a first light-blocking layer 610, first to third color filters 620R, 620G, and 620B, a refractive layer 630, and a water-repellent layer 650. In this case, the first light-blocking layer 610, the first to third color filters 620R, 620G, and 620B, and the water-repellent layer 650 may be the same as or similar to those described above with reference to FIGS. 10A to 10D, and thus, redundant descriptions thereof will be omitted for conciseness purposes.

The refractive layer 630 may include a first base layer 631 and low-refractive particles 632. In this case, the first base layer 631 and the low-refractive particles 632 may be the same as or similar to those described above with reference to FIGS. 10A to 10D, and thus, redundant descriptions thereof will be omitted for conciseness purposes.

As illustrated in FIGS. 13A and 13B, the refractive layer 630 may be arranged not only in the first to third upper opening portions 610OP1, 6100P2, and 610OP3 but also on the upper surface of the first light-blocking layer 610 (e.g., disposed directly thereon in the z direction).

Referring to FIG. 13A, in an embodiment, the anti-reflection layer 600 may include scattering particles 642 arranged in the first light-blocking layer 610. In this case, the scattering particles 642 may be the same as or similar to those described above with reference to FIGS. 10A to 10D.

Referring to FIG. 13B, in an embodiment, the anti-reflection layer 600 may not include a scattering layer or scattering particles 642.

In an embodiment, the display apparatus may have a similar form to that illustrated in FIG. 10A. For example, the display apparatus may include an encapsulation member including an encapsulation substrate and a sealing portion and may include the touch sensor layer 500 arranged over the encapsulation substrate. Also, the anti-reflection layer 600 may be arranged over the touch sensor layer 500. In this case, the anti-reflection layer 600 may be an anti-reflection layer 600 in the form illustrated in FIG. 13A or 13B.

In an embodiment, the display apparatus may have a similar form to that illustrated in FIG. 10B. For example, the anti-reflection layer 600 may be arranged over the encapsulation substrate, and the touch sensor layer 500 may be arranged over the anti-reflection layer 600. In this case, the anti-reflection layer 600 may be an anti-reflection layer 600 in the form illustrated in FIG. 13A or 13B.

In an embodiment, the display apparatus may have a similar form to that illustrated in FIG. 10C. For example, the touch sensor layer 500 may be arranged over the encapsulation layer, and the anti-reflection layer 600 may be arranged over the touch sensor layer 500. In this case, the anti-reflection layer 600 may be an anti-reflection layer 600 in the form illustrated in FIG. 13A or 13B.

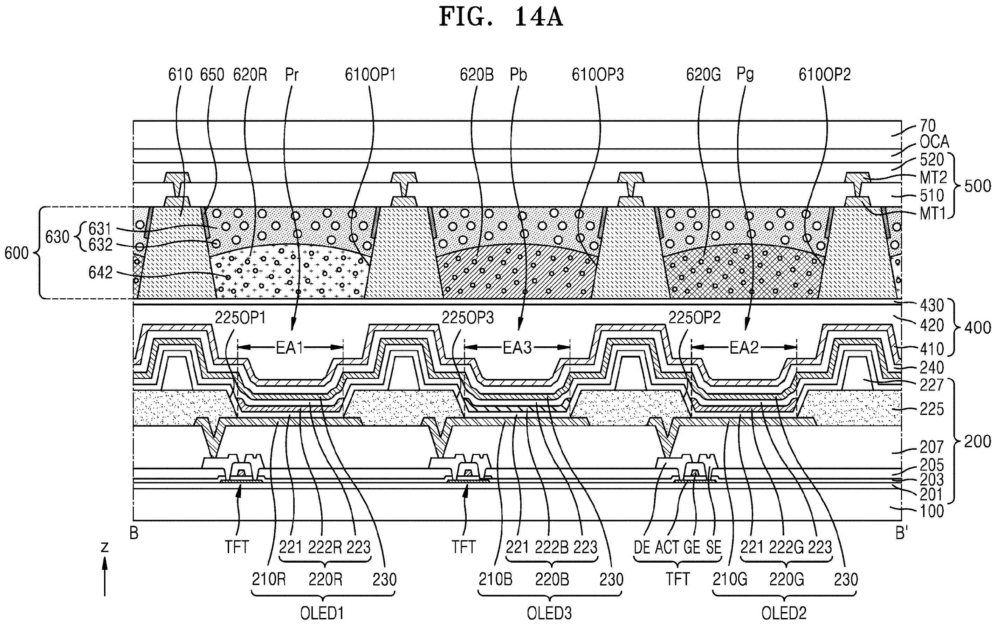

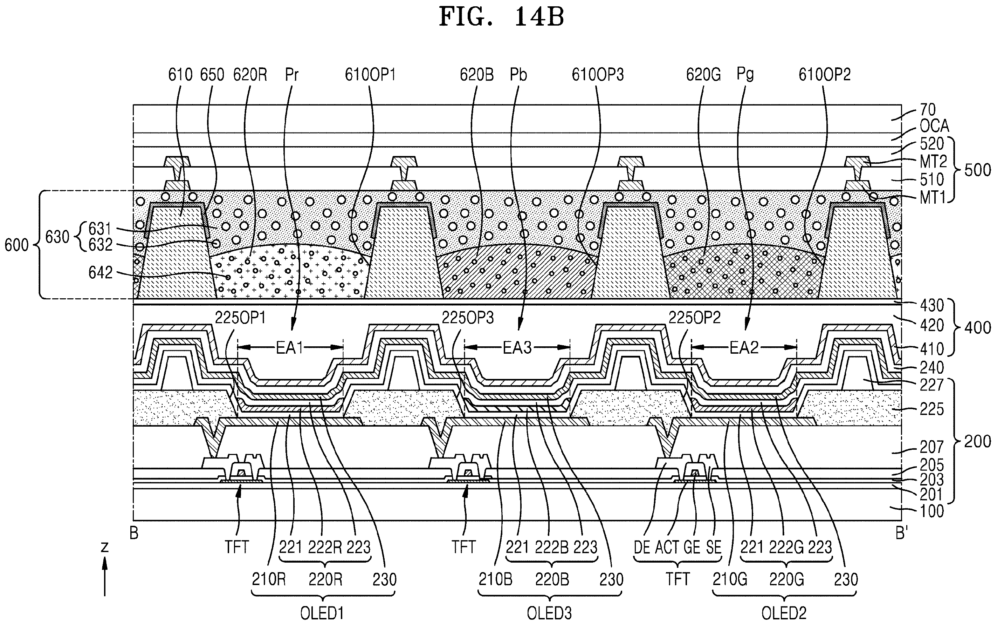

FIGS. 14A and 14B are cross-sectional views schematically illustrating a portion of a display apparatus according to embodiments. In FIGS. 14A and 14B, the same reference numerals as those in FIGS. 10A to 10D may denote the same members as those in FIGS. 10A to 10D. Hereinafter, differences from FIGS. 10A to 10D will be mainly described in detail for economy of explanation.

Referring to FIGS. 14A and 14B, in an embodiment the display apparatus may include a substrate 100, a display layer 200, an encapsulation member 400, an anti-reflection layer 600, a touch sensor layer 500, an adhesive layer OCA, and a cover member 70. In this case, the substrate 100, the display layer 200, the encapsulation member 400, the touch sensor layer 500, the adhesive layer OCA, and the cover member 70 may be the same as or similar to those described above with reference to FIGS. 10C and 10D, and thus, redundant descriptions thereof will be omitted for conciseness purposes.

The anti-reflection layer 600 may include a first light-blocking layer 610, first to third color filters 620R, 620G, and 620B, a refractive layer 630, and a water-repellent layer 650. In this case, the first light-blocking layer 610, the first to third color filters 620R, 620G, and 620B, and the water-repellent layer 650 may be the same as or similar to those described above with reference to FIGS. 10A to 10D, and thus, redundant descriptions thereof will be omitted for conciseness purposes.

The refractive layer 630 may include a first base layer 631 and low-refractive particles 632. In this case, the first base layer 631 and the low-refractive particles 632 may be the same as or similar to those described above with reference to FIGS. 10A to 10D, and thus, redundant descriptions thereof will be omitted for conciseness purposes.

Referring to FIG. 14A, the refractive layer 630 may be arranged in each of the first to third upper opening portions 610OP1, 610OP2, and 610OP3. In this case, the refractive layer 630 may be the same as or similar to that described above with reference to FIGS. 10A to 10D or FIG. 11, and thus, redundant descriptions thereof will be omitted for conciseness purposes.

Referring to FIG. 14B, the refractive layer 630 may be arranged not only in the first to third upper opening portions 610OP1, 610OP2, and 610OP3 but also on the upper surface of the first light-blocking layer 610 (e.g., disposed directly thereon in the z direction).

Referring to FIGS. 14A and 14B, in an embodiment, the anti-reflection layer 600 may include scattering particles 642 arranged in at least one of the first to third color filters 620R, 620G, and 620B. For example, as shown in FIGS. 14A and 14B in an embodiment the scattering particles 642 may be included in each of the first to third color filters 620R, 620G, and 620B. In this case, the scattering particles 642 may be the same as or similar to those described above with reference to FIGS. 10A to 10D. When the scattering particles 642 are arranged in at least one of the first to third color filters 620R, 620G, and 620B as described above, the light emitted from at least one of the first to third organic light emitting diodes OLED1, OLED2, and OLED3 in which the scattering particles 642 are arranged may be scattered in at least one of the first to third color filters 620R, 620G, and 620B and accordingly the brightness of the light passing through at least one of the first to third color filters 620R, 620G, and 620B corresponding to at least one of the first to third organic light emitting diodes OLED1, OLED2, and OLED3 may increase. Hereinafter, for convenience of description, a detailed description will be given mainly of a case where the scattering particles 642 are arranged in each of the first to third color filters 620R, 620G, and 620B.

In an embodiment, the display apparatus may have a similar form to that illustrated in FIG. 10A. For example, the display apparatus may include an encapsulation member including an encapsulation substrate and a sealing portion and may include the touch sensor layer 500 arranged over the encapsulation substrate. Also, the anti-reflection layer 600 may be arranged over the touch sensor layer 500. In this case, the anti-reflection layer 600 may be an anti-reflection layer 600 in the form illustrated in FIG. 14A or 14B.

In an embodiment, the display apparatus may have a similar form to that illustrated in FIG. 10B. For example, the anti-reflection layer 600 may be arranged over the encapsulation layer, and the touch sensor layer 500 may be arranged over the anti-reflection layer 600. In this case, the anti-reflection layer 600 may be an anti-reflection layer 600 in the form illustrated in FIG. 14A or 14B.

In an embodiment, the display apparatus may have a similar form to that illustrated in FIG. 10C. For example, the touch sensor layer 500 may be arranged over the encapsulation substrate, and the anti-reflection layer 600 may be arranged over the touch sensor layer 500. In this case, the anti-reflection layer 600 may be an anti-reflection layer 600 in the form illustrated in FIG. 14A or 14B.

In an embodiment, the scattering particles 642 may not be included in each of the first to third color filters 620R, 620G, and 620B.

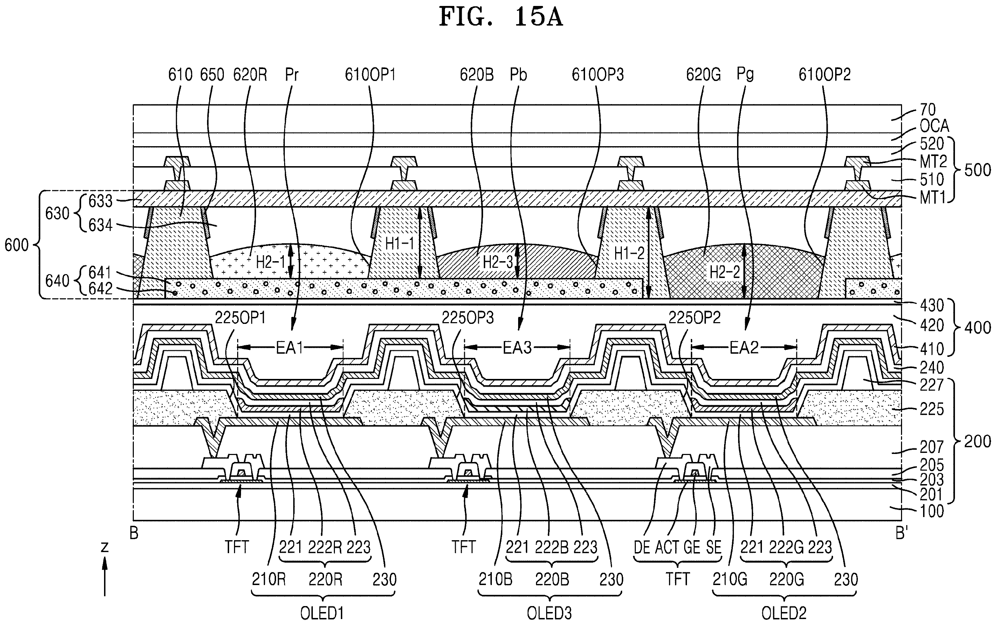

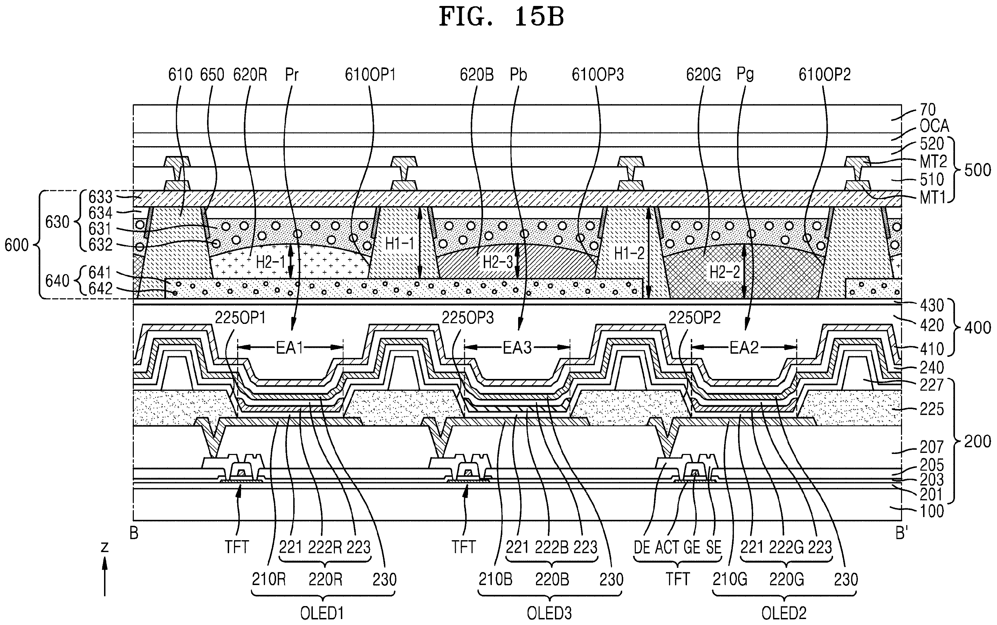

FIGS. 15A and 15B are cross-sectional views schematically illustrating a portion of a display apparatus according to embodiments. In FIGS. 15A and 15B, the same reference numerals as those in FIGS. 10A to 10D may denote the same members as those in FIGS. 10A to 10D. Hereinafter, differences from FIGS. 10A to 10D will be mainly described in detail for economy of explanation.

Referring to FIGS. 15A and 15B, in an embodiment the display apparatus may include a substrate 100, a display layer 200, an encapsulation member 400, an anti-reflection layer 600, a touch sensor layer 500, an adhesive layer OCA, and a cover member 70. In this case, the substrate 100, the display layer 200, the encapsulation member 400, the touch sensor layer 500, the adhesive layer OCA, and the cover member 70 may be the same as or similar to those described above with reference to FIGS. 10C and 10D, and thus, redundant descriptions thereof will be omitted for conciseness purposes.

The anti-reflection layer 600 may include a first light-blocking layer 610, first to third color filters 620R, 620G, and 620B, a refractive layer 630, a scattering layer 640, and a water-repellent layer 650. In this case, the first light-blocking layer 610, the first to third color filters 620R, 620G, and 620B, the scattering layer 640 including a second base layer 641 and scattering particles 642, and the water-repellent layer 650 may be the same as or similar to those described above with reference to FIGS. 10A to 10D, and thus, redundant descriptions thereof will be omitted for conciseness purposes.

As illustrated in FIG. 15A, the refractive layer 630 may include an upper substrate 633 arranged over the first light-blocking layer 610 and spaced apart from each of the first to third color filters 620R, 620G, and 620B and a gas layer 634 disposed between the upper substrate 633 and each of the first to third color filters 620R, 620G, and 620B. The upper substrate 633 may directly contact the first light-blocking layer 610 and may be arranged to be spaced apart from the upper surface of each of the first to third color filters 620R, 620G, and 620B. In an embodiment, the upper substrate 633 may include a transparent material such as glass and acryl. The gas layer 634 may be arranged between each of the first to third color filters 620R, 620G, and 620B and the upper substrate 633 (e.g., disposed directly therebetween in the z direction). Gas (e.g., air) may be stored in the gas layer 634. In the above case, the refractive index of the refractive layer 630 may be about 1.

Referring to FIG. 15B, the refractive layer 630 may include a first base layer 631, low-refractive particles 632, a gas layer 634, and an upper substrate 633. In this case, the first base layer 631 and the low-refractive particles 632 may be the same as or similar to those described above with reference to FIGS. 10A to 10D, and thus, redundant descriptions thereof will be omitted for conciseness purposes. Also, the gas layer 634 and the upper substrate 633 may be the same as or similar to those described above, and thus, redundant descriptions thereof will be omitted for conciseness purposes.

In an embodiment, the display apparatus may have a similar form to that illustrated in FIG. 10A. For example, the display apparatus may include an encapsulation member including an encapsulation substrate and a sealing portion and may include the touch sensor layer 500 arranged over the encapsulation substrate. Also, the anti-reflection layer 600 may be arranged over the touch sensor layer 500. In this case, the anti-reflection layer 600 may include a refractive layer 630 in the form illustrated in FIG. 15A or 15B.

In an embodiment, the display apparatus may have a similar form to that illustrated in FIG. 10B. For example, the anti-reflection layer 600 may be arranged over the encapsulation substrate, and the touch sensor layer 500 may be arranged over the anti-reflection layer 600. In this case, the anti-reflection layer 600 may include a refractive layer 630 in the form illustrated in FIG. 15A or 15B.

In an embodiment, the display apparatus may have a similar form to that illustrated in FIG. 10C. For example, the touch sensor layer 500 may be arranged over the encapsulation layer, and the anti-reflection layer 600 may be arranged over the touch sensor layer 500. In this case, the anti-reflection layer 600 may include a refractive layer 630 in the form illustrated in FIG. 15A or 15B.

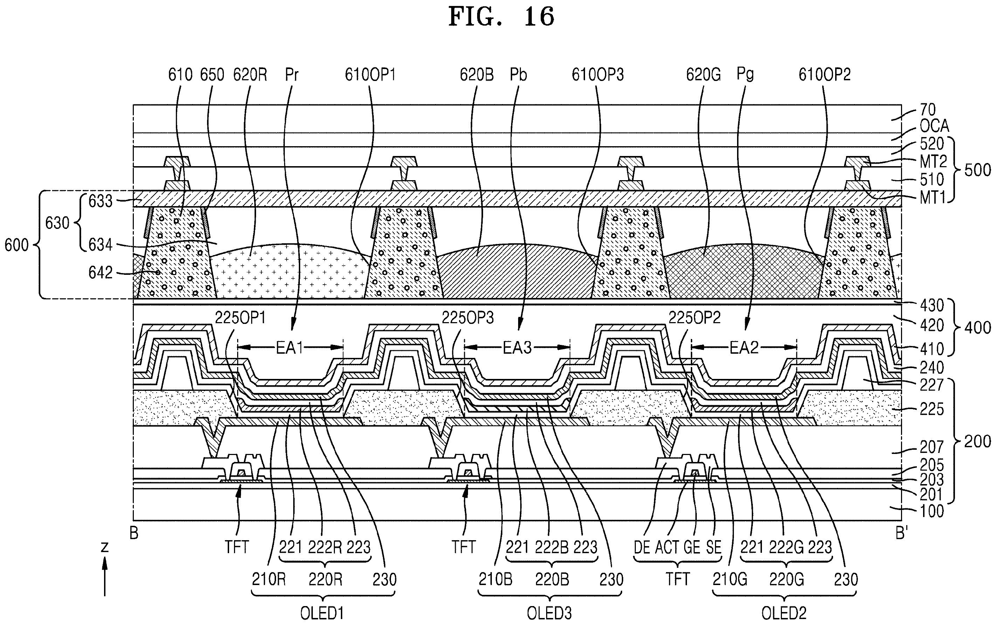

FIG. 16 is a cross-sectional view schematically illustrating a portion of a display apparatus according to embodiments. In FIG. 16, the same reference numerals as those in FIGS. 10A to 10D may denote the same members as those in FIGS. 10A to 10D. Hereinafter, differences from FIGS. 10A to 10D will be mainly described in detail for economy of explanation.

Referring to FIG. 16, in an embodiment the display apparatus may include a substrate 100, a display layer 200, an encapsulation member 400, an anti-reflection layer 600, a touch sensor layer 500, an adhesive layer OCA, and a cover member 70. In this case, the substrate 100, the display layer 200, the encapsulation member 400, the touch sensor layer 500, the adhesive layer OCA, and the cover member 70 may be the same as or similar to those described above with reference to FIGS. 10C and 10D, and thus, redundant descriptions thereof will be omitted for conciseness purposes.

The anti-reflection layer 600 may include a first light-blocking layer 610, first to third color filters 620R, 620G, and 620B, a refractive layer 630, scattering particles 642, and a water-repellent layer 650. In this case, the first light-blocking layer 610, the first to third color filters 620R, 620G, and 620B, and the water-repellent layer 650 may be the same as or similar to those described above with reference to FIGS. 10A to 10D, and thus, redundant descriptions thereof will be omitted for conciseness purposes.

The refractive layer 630 may include an upper substrate 633 arranged over the first light-blocking layer 610 and spaced apart from each of the first to third color filters 620R, 620G, and 620B and a gas layer 634 disposed between the upper substrate 633 and each of the first to third color filters 620R, 620G, and 620B. In this case, the upper substrate 633 and the gas layer 634 may be the same as or similar to those described above with reference to FIG. 15A, and thus, redundant descriptions thereof will be omitted for conciseness purposes.

The scattering particles 642 may be arranged in the first light-blocking layer 610. In this case, the scattering particles 642 may be the same as or similar to those described above with reference to FIGS. 10A to 10D, and thus, redundant descriptions thereof will be omitted for conciseness purposes.

In an embodiment, the display apparatus may have a similar form to that illustrated in FIG. 10A. For example, the display apparatus may include an encapsulation member including an encapsulation substrate and a sealing portion and may include the touch sensor layer 500 arranged over the encapsulation substrate. Also, the anti-reflection layer 600 may be arranged over the touch sensor layer 500. In this case, the anti-reflection layer 600 may be an anti-reflection layer 600 in the form illustrated in FIG. 16.

In an embodiment, the display apparatus may have a similar form to that illustrated in FIG. 10B. For example, the anti-reflection layer 600 may be arranged over the encapsulation substrate, and the touch sensor layer 500 may be arranged over the anti-reflection layer 600. In this case, the anti-reflection layer 600 may be an anti-reflection layer 600 in the form illustrated in FIG. 16.

In an embodiment, the display apparatus may have a similar form to that illustrated in FIG. 10C. For example, the touch sensor layer 500 may be arranged over the encapsulation layer, and the anti-reflection layer 600 may be arranged over the touch sensor layer 500. In this case, the anti-reflection layer 600 may be an anti-reflection layer 600 in the form illustrated in FIG. 16.

In the above case, a first base layer 631 and low-refractive particles 632 may be arranged in the gas layer 634 as described above with reference to FIG. 15B.

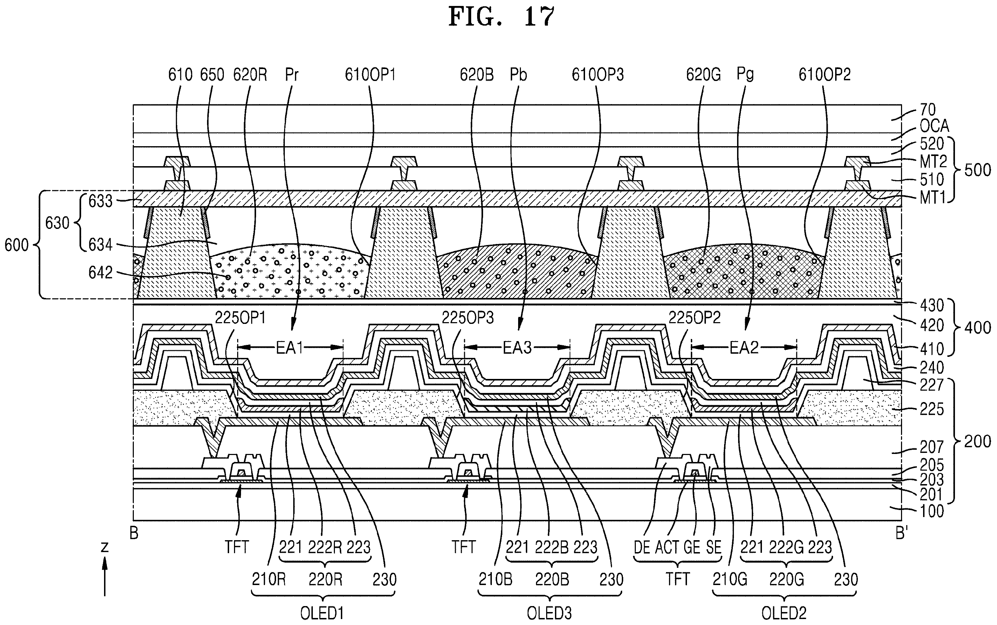

FIG. 17 is a cross-sectional view schematically illustrating a portion of a display apparatus according to embodiments. In FIG. 17, the same reference numerals as those in FIGS. 10A to 10D may denote the same members as those in FIGS. 10A to 10D. Hereinafter, differences from FIGS. 10A to 10D will be mainly described in detail for economy of explanation.

Referring to FIG. 17, in an embodiment the display apparatus may include a substrate 100, a display layer 200, an encapsulation member 400, an anti-reflection layer 600, a touch sensor layer 500, an adhesive layer OCA, and a cover member 70. In this case, the substrate 100, the display layer 200, the encapsulation member 400, the touch sensor layer 500, the adhesive layer OCA, and the cover member 70 may be the same as or similar to those described above with reference to FIGS. 10C and 10D, and thus, redundant descriptions thereof will be omitted for conciseness purposes.

The anti-reflection layer 600 may include a first light-blocking layer 610, first to third color filters 620R, 620G, and 620B, a refractive layer 630, scattering particles 642, and a water-repellent layer 650. In this case, the first light-blocking layer 610, the first to third color filters 620R, 620G, and 620B, and the water-repellent layer 650 may be the same as or similar to those described above with reference to FIGS. 10A to 10D, and thus, redundant descriptions thereof will be omitted for conciseness purposes.

The refractive layer 630 may include an upper substrate 633 arranged over the first light-blocking layer 610 and spaced apart from each of the first to third color filters 620R, 620G, and 620B and a gas layer 634 disposed between the upper substrate 633 and each of the first to third color filters 620R, 620G, and 620B (e.g., in the z direction). In this case, the upper substrate 633 and the gas layer 634 may be the same as or similar to those described above with reference to FIG. 15A, and thus, redundant descriptions thereof will be omitted for conciseness purposes.

The scattering particles 642 may be arranged in at least one of the first to third color filters 620R, 620G, and 620B. In this case, the scattering particles 642 may be the same as or similar to those described above with reference to FIGS. 10A to 10D, and thus, redundant descriptions thereof will be omitted for conciseness purposes.

In an embodiment, the display apparatus may have a similar form to that illustrated in FIG. 10A. For example, the display apparatus may include an encapsulation member including an encapsulation substrate and a sealing portion and may include the touch sensor layer 500 arranged over the encapsulation substrate. Also, the anti-reflection layer 600 may be arranged over the touch sensor layer 500. In this case, the anti-reflection layer 600 may be an anti-reflection layer 600 in the form illustrated in FIG. 17.

In an embodiment, the display apparatus may have a similar form to that illustrated in FIG. 10B. For example, the anti-reflection layer 600 may be arranged over the encapsulation substrate, and the touch sensor layer 500 may be arranged over the anti-reflection layer 600. In this case, the anti-reflection layer 600 may be an anti-reflection layer 600 in the form illustrated in FIG. 17.

In an embodiment, the display apparatus may have a similar form to that illustrated in FIG. 10C. For example, the touch sensor layer 500 may be arranged over the encapsulation layer, and the anti-reflection layer 600 may be arranged over the touch sensor layer 500. In this case, the anti-reflection layer 600 may be an anti-reflection layer 600 in the form illustrated in FIG. 17.

In an embodiment, a first base layer 631 and low-refractive particles 632 may be arranged in the gas layer 634 as described above with reference to FIG. 15B.

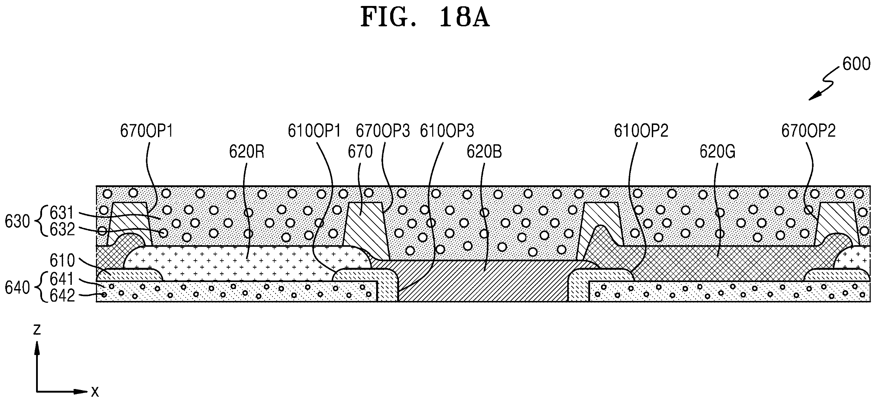

FIGS. 18A to 18D are cross-sectional views schematically illustrating a portion of a display apparatus according to embodiments.

Referring to FIGS. 18A to 18D, in an embodiment the display apparatus may include a substrate, a display layer, an encapsulation member, an anti-reflection layer 600, a touch sensor layer, an adhesive layer, and a cover member. In this case, the substrate, the display layer, the encapsulation member, the touch sensor layer, the adhesive layer, and the cover member may be the same as or similar to those described above with reference to FIGS. 10A to 10D, and thus, redundant descriptions thereof will be omitted for conciseness purposes.

The encapsulation member may include an encapsulation substrate and a sealing portion as described above with reference to FIG. 10A or 10B or may include an encapsulation layer as described above with reference to FIG. 10C or 10D. Also, the touch sensor layer may be arranged over the encapsulation member as described above with reference to FIG. 10A or 10C, and the anti-reflection layer 600 may be arranged over the touch sensor layer. In an embodiment, as illustrated in FIGS. 10B and 10D, the anti-reflection layer 600 may be arranged over the encapsulation member, and the touch sensor layer may be arranged over the anti-reflection layer 600.

In an embodiment, the anti-reflection layer 600 may include a first light-blocking layer 610, first to third color filters 620R, 620G, and 620B, a refractive layer 630, a scattering layer 640, and a second light-blocking layer 670. The second light-blocking layer 670 may be referred to as an additional light-blocking layer.

The first light-blocking layer 610 may include first to third upper opening portions 610OP1, 6100P2, and 610OP3 corresponding to the first to third lower opening portions illustrated in FIGS. 10A to 10D. In this case, the first to third upper opening portions 610OP1, 6100P2, and 610OP3 may be arranged to correspond to the respective subpixels.

At least a portion of each of the first to third color filters 620R, 620G, and 620B may be arranged in a corresponding one of the first to third upper opening portions 610OP1, 6100P2, and 610OP3. Also, adjacent color filters among the first to third color filters 620R, 620G, and 620B may at least partially overlap each other (e.g., in the z direction). The overlapping portion of adjacent color filters among the first to third color filters 620R, 620G, and 620B may be arranged on the upper surface of the first light-blocking layer 610. This may prevent mixing between adjacent color filters.

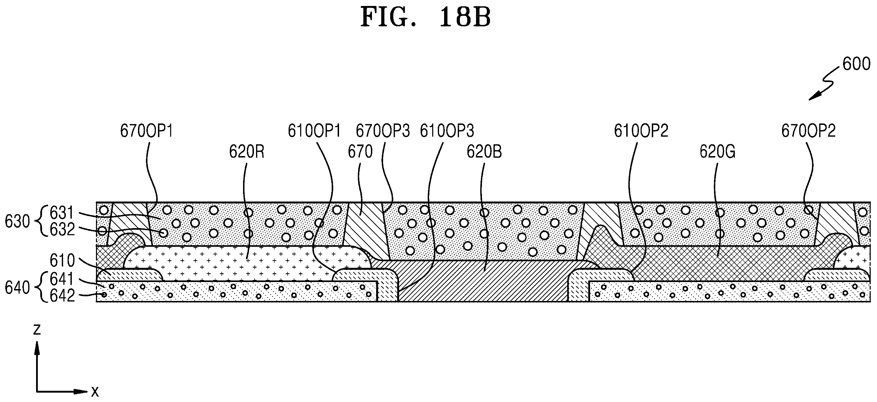

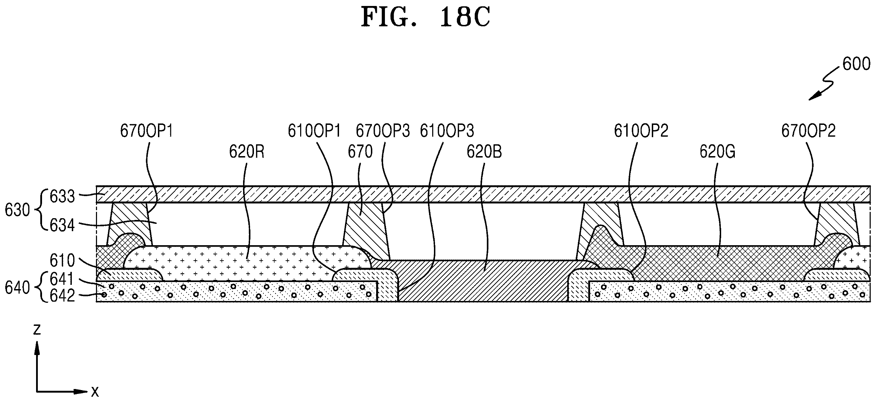

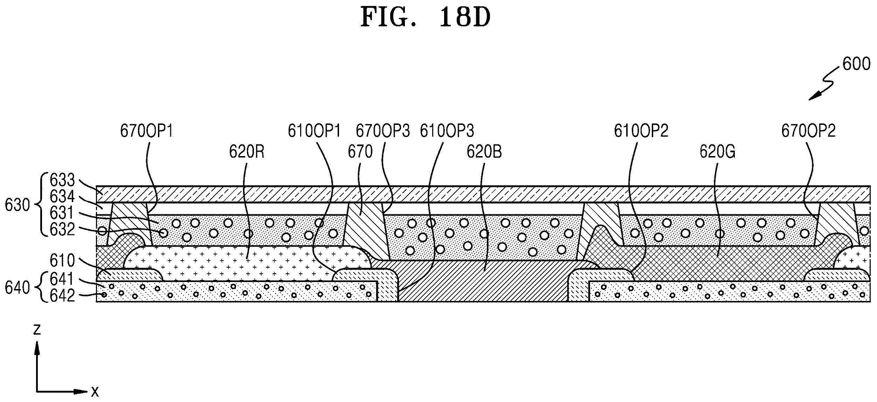

The refractive layer 630 may have various forms. For example, as illustrated in FIG. 18A or 18B, the refractive layer 630 may include a first base layer 631 and low-refractive particles 632. In an embodiment, as illustrated in FIG. 18C, the refractive layer 630 may include an upper substrate 633 and a gas layer 634. In an embodiment, as illustrated in FIG. 18D, the refractive layer 630 may include a first base layer 631, low-refractive particles 632, an upper substrate 633, and a gas layer 634. In this case, the first base layer 631, the low-refractive particles 632, the upper substrate 633, and the gas layer 634 may be the same as or similar to those described above with reference to FIGS. 10A to 17, and thus, redundant descriptions thereof will be omitted for conciseness purposes.

The second light-blocking layer 670 may include a second opening portion such that each of the first to third color filters 620R, 620G, and 620B is exposed to the outside. In this case, the second opening portion may include a second-1 opening portion 670OP1 arranged to correspond to (e.g., overlap in the z direction with) the first upper opening portion 610OP1 to expose the first color filter 620R to the outside, a second-2 opening portion 670OP2 arranged to correspond to (e.g., overlap in the z direction with) the second upper opening portion 610OP2 to expose the second color filter 620G to the outside, and a second-3 opening portion 670OP3 arranged to correspond to (e.g., overlap in the z direction with) the third upper opening portion 610OP3 to expose the third color filter 620B to the outside. The second opening portions may be referred to as additional opening portions. In an embodiment, the width of a corresponding second opening portion measured in one direction as described above may be greater than the width of each upper opening portion 610OP1, 610OP2 or 610OP3. For example, the width of the second-1 opening portion 670OP1 may be greater than the width of the first upper opening portion 610OP1. Also, the width of the second-2 opening portion 670OP2 may be greater than the width of the second upper opening portion 610OP2. The width of the second-3 opening portion 670OP3 may be greater than the width of the third upper opening portion 610OP3.

In the above case, when the refractive layer 630 includes the first base layer 631 and the low-refractive particles 632, it may be arranged over the second light-blocking layer 670 (e.g., disposed directly above the second light-blocking layer 670 in the z direction) and in the second-1 to second-3 opening portions 670OP1, 670OP2, and 670OP3 as illustrated in FIG. 18A. In an embodiment, when the refractive layer 630 includes the first base layer 631 and the low-refractive particles 632, the refractive layer 630 may be arranged in the second-1 to second-3 opening portions 670OP1, 670OP2, and 670OP3 as illustrated in FIG. 18B or 18D. In this case, the upper surface of the second light-blocking layer 670 may be arranged higher than the highest point of each of the first to third color filters 620R, 620G, and 620B.

In the above case, the scattering layer 640 may be arranged under the first light-blocking layer 610 (e.g., in the -z direction) as illustrated in FIGS. 18A to 18D. In this case, the scattering layer 640 may include a second base layer 641 and scattering particles 642. Also, the scattering layer 640 may be inserted into a portion of the first light-blocking layer 610. For example, in an embodiment the scattering layer 640 may include an opening area arranged to correspond to the second organic light emitting diode OLED2 illustrated in FIGS. 10A to 10D. The scattering layer 640 may not be arranged in the opening area. However, embodiments of the present disclosure are not necessarily limited thereto and the opening area of the scattering layer 640 may be variously arranged with respect to the first to third organic light emitting diodes OLED1 to OLED3.

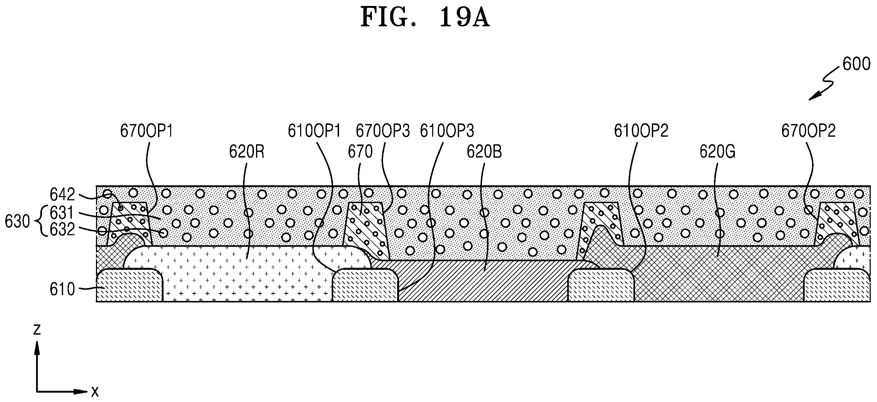

FIGS. 19A to 19D are cross-sectional views schematically illustrating a portion of a display apparatus according to embodiments. In FIGS. 19A to 19D, the same reference numerals as those in FIGS. 18A to 18D may denote the same members as those therein. Hereinafter, differences from FIGS. 18A to 18D will be mainly described in detail.

Referring to FIGS. 19A to 19D, in an embodiment the display apparatus may include a substrate, a display layer, an encapsulation member, an anti-reflection layer 600, a touch sensor layer, an adhesive layer, and a cover member. In this case, the substrate, the display layer, the encapsulation member, the touch sensor layer, the adhesive layer, and the cover member may be the same as or similar to those described above with reference to FIGS. 10A to 10D, and thus, redundant descriptions thereof will be omitted for conciseness purposes.

The encapsulation member may include an encapsulation substrate and a sealing portion as described above with reference to FIG. 10A or 10B or may include an encapsulation layer as described above with reference to FIG. 10C or 10D. Also, the touch sensor layer may be arranged over the encapsulation member as described above with reference to FIG. 10A or 10C, and the anti-reflection layer 600 may be arranged over the touch sensor layer. In an embodiment, as illustrated in FIGS. 10B and 10D, the anti-reflection layer 600 may be arranged over the encapsulation member, and the touch sensor layer may be arranged over the anti-reflection layer 600.

The anti-reflection layer 600 may include a first light-blocking layer 610, first to third color filters 620R, 620G, and 620B, a refractive layer 630, scattering particles 642, and a second light-blocking layer 670. In this case, the first light-blocking layer 610, the first to third color filters 620R, 620G, and 620B, the refractive layer 630, and the second light-blocking layer 670 may be the same as or similar to those described above with reference to FIGS. 18A to 18D, and thus, redundant descriptions thereof will be omitted for conciseness purposes.

The scattering particles 642 may be arranged in at least a portion of the first light-blocking layer 610 and/or at least a portion of the second light-blocking layer 670. Hereinafter, for convenience of description, a detailed description will be given mainly of a case where the scattering particles 642 are arranged in the second light-blocking layer 670.

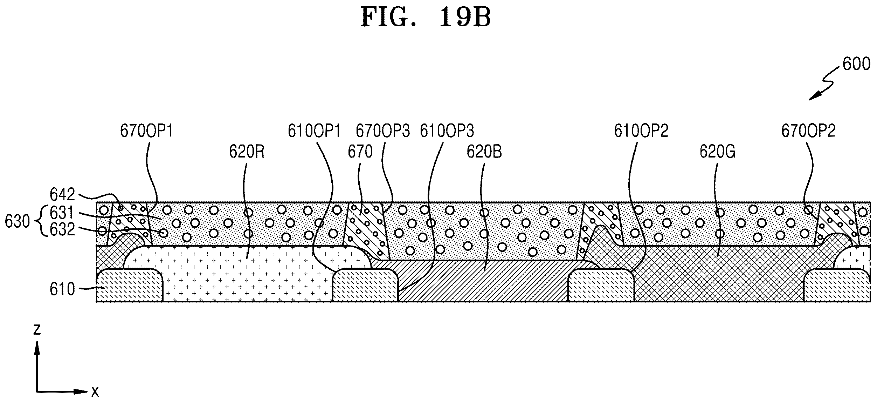

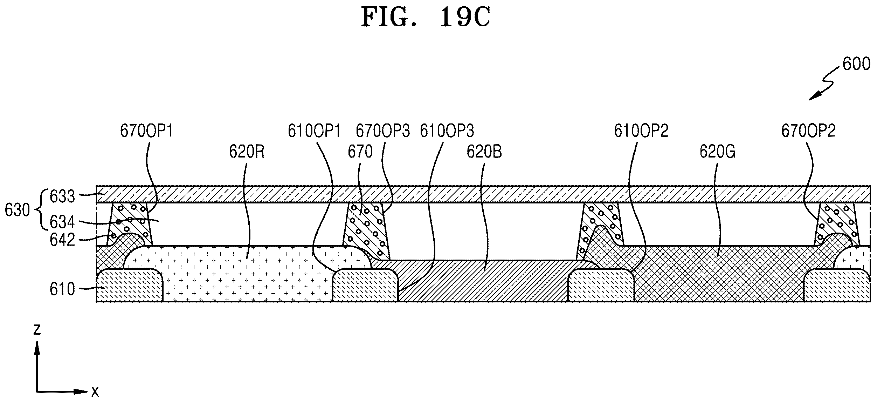

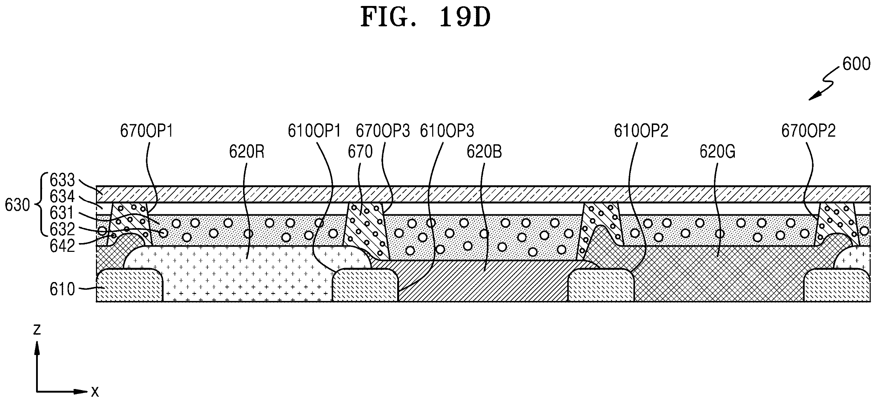

In the above case, the refractive layer 630 may include a first base layer 631 and low-refractive particles 632 as illustrated in FIG. 19A or 19B. In this case, the refractive layer 630 may be arranged over the second light-blocking layer 670 (e.g., disposed directly above the second light-blocking layer 670 in the z direction) and in the second-1 to second-3 opening portions 670OP1, 670OP2, and 670OP3 corresponding to the first to third upper opening portions 610OP1, 610OP2, and 610OP3 as illustrated in FIG. 19A or may not be arranged over the second light-blocking layer 670 and may be arranged in the second-1 to second-3 opening portions 670OP1, 670OP2, and 670OP3 as illustrated in FIG. 19B. In an embodiment, the refractive layer 630 may include an upper substrate 633 and a gas layer 634 as illustrated in FIG. 19C. In an embodiment, the refractive layer 630 may include a first base layer 631, low-refractive particles 632, an upper substrate 633, and a gas layer 634 as illustrated in FIG. 19D. In this case, similarly to that illustrated in FIG. 19B, the refractive layer 630 may be arranged in the second-1 to second-3 opening portions 670OP1, 670OP2, and 670OP3.

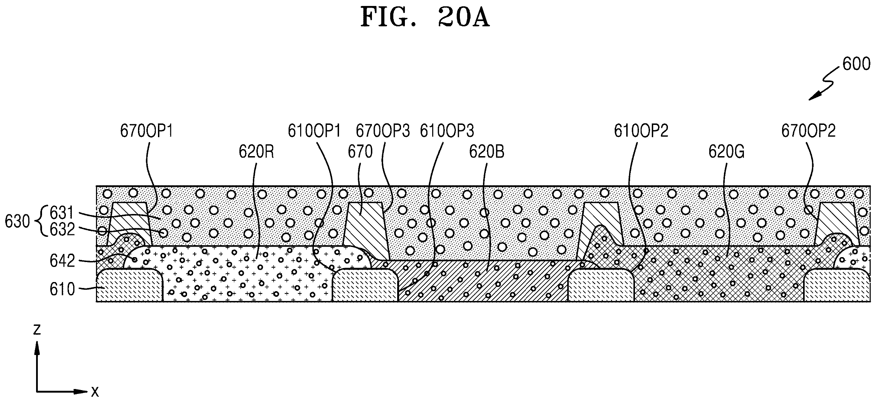

FIGS. 20A to 20D are cross-sectional views schematically illustrating a portion of a display apparatus according to embodiments. In FIGS. 20A to 20D, the same reference numerals as those in FIGS. 18A to 18D may denote the same members as those therein. Hereinafter, differences from FIGS. 18A to 18D will be mainly described in detail.

Referring to FIGS. 20A to 20D, in an embodiment the display apparatus may include a substrate, a display layer, an encapsulation member, an anti-reflection layer 600, a touch sensor layer, an adhesive layer, and a cover member. In this case, the substrate, the display layer, the encapsulation member, the touch sensor layer, the adhesive layer, and the cover member may be the same as or similar to those described above with reference to FIGS. 10A to 10D, and thus, redundant descriptions thereof will be omitted for conciseness purposes.

The encapsulation member may include an encapsulation substrate and a sealing portion as described above with reference to FIG. 10A or 10B or may include an encapsulation layer as described above with reference to FIG. 10C or 10D. Also, the touch sensor layer may be arranged over the encapsulation member as described above with reference to FIG. 10A or 10C, and the anti-reflection layer 600 may be arranged over the touch sensor layer. In an embodiment, as illustrated in FIGS. 10B and 10D, the anti-reflection layer 600 may be arranged over the encapsulation member, and the touch sensor layer may be arranged over the anti-reflection layer 600.

The anti-reflection layer 600 may include a first light-blocking layer 610, first to third color filters 620R, 620G, and 620B, a refractive layer 630, scattering particles 642, and a second light-blocking layer 670. In this case, the first light-blocking layer 610, the first to third color filters 620R, 620G, and 620B, the refractive layer 630, and the second light-blocking layer 670 may be the same as or similar to those described above with reference to FIGS. 18A to 18D, and thus, redundant descriptions thereof will be omitted for conciseness purposes.

The scattering particles 642 may be arranged in at least one of the first to third color filters 620R, 620G, and 620B. Hereinafter, for convenience of description, a detailed description will be given mainly of a case where the scattering particles 642 are arranged in each of the first to third color filters 620R, 620G, and 620B.

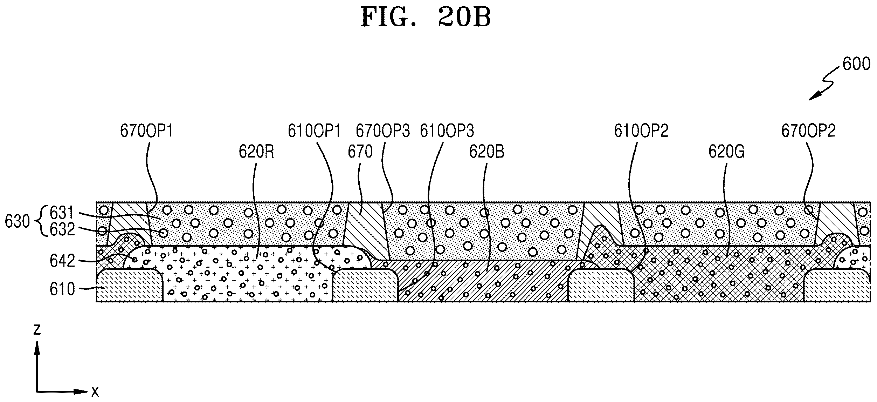

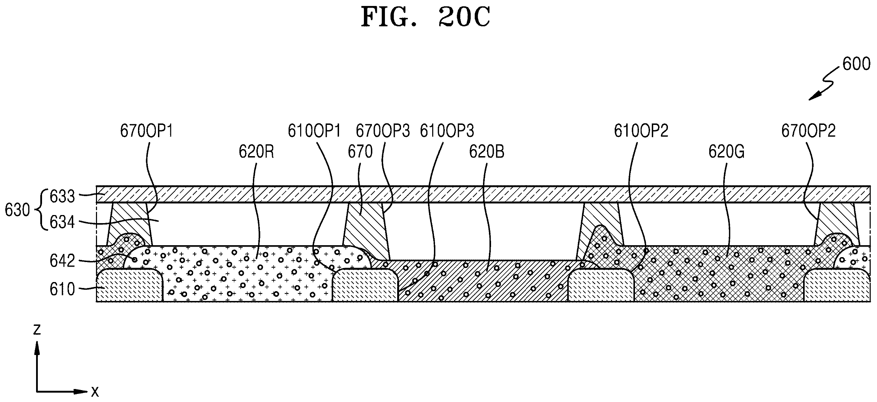

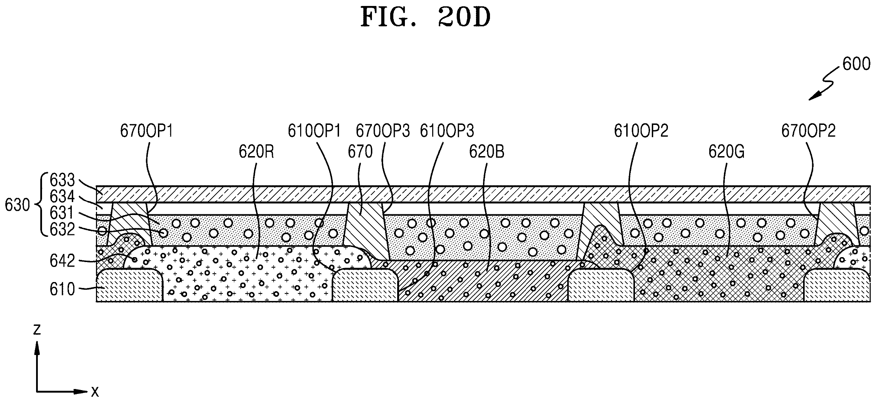

In the above case, the refractive layer 630 may include a first base layer 631 and low-refractive particles 632 as illustrated in FIG. 20A or 20B. In this case, the refractive layer 630 may be arranged over the second light-blocking layer 670 and in the second-1 to second-3 opening portions 670OP1, 670OP2, and 670OP3 corresponding to the first to third upper opening portions 610OP1, 610OP2, and 610OP3 as illustrated in FIG. 20A or may not be arranged over the second light-blocking layer 670 and may be arranged in the second-1 to second-3 opening portions 670OP1, 670OP2, and 670OP3 as illustrated in FIG. 20B. In an embodiment, the refractive layer 630 may include an upper substrate 633 and a gas layer 634 as illustrated in FIG. 20C. In an embodiment, the refractive layer 630 may include a first base layer 631, low-refractive particles 632, an upper substrate 633, and a gas layer 634 as illustrated in FIG. 20D. In this case, similarly to that illustrated in FIG. 20B, the refractive layer 630 may be arranged in the second-1 to second-3 opening portions 670OP1, 670OP2, and 670OP3.

Moreover, herein, it has been described that the scattering particles 642 are arranged in the first base layer 631, the light-blocking layer, or at least one of the first to third color filters 620R, 620G, and 620B; however, embodiments of the present disclosure are not necessarily limited thereto, and the scattering particles 642 may also be arranged in at least two of the first base layer 631, the light-blocking layer, or at least one of the first to third color filters 620R, 620G, and 620B.

The display apparatus and electronic apparatus according to the present embodiments may increase the light efficiency.

The display apparatus and electronic apparatus according to the present embodiments may provide a clear image by including the color filter arranged to correspond to the emission area of the subpixel.

The display apparatus and electronic apparatus according to the present embodiments may increase the front transmittance of the light emitted from the display panel.

It should be understood that embodiments described herein should be considered in a descriptive sense only and not for purposes of limitation. Descriptions of features or aspects within each embodiment should typically be considered as available for other similar features or aspects in other embodiments. While one or more non-limiting embodiments have been described with reference to the figures, it will be understood by those of ordinary skill in the art that various changes in form and details may be made therein without departing from the scope of the present disclosure.

## Claims

1. A display panel (10) comprising:
a substrate (100);
a display layer (200) arranged over the substrate (100) and comprising a plurality of display elements emitting light of different colors;
an encapsulation member (400) coupled to the substrate (100) and shielding the display layer (200);
a light-blocking layer (610) arranged over the encapsulation member (400) and comprising a plurality of opening portions respectively corresponding to the plurality of display elements;
a plurality of color filters (620R, 620G, 620B) arranged in the light-blocking layer (610) to respectively correspond to the plurality of display elements; and
a refractive layer (630) arranged over the plurality of color filters (620R, 620G, 620B) and having a refractive index in a range of about 1 to about 1.5.

2. The display panel (10) of claim 1, further comprising a scattering layer (640) arranged between the light-blocking layer and the encapsulation member (400) and overlapping at least one of the plurality of display elements.

3. The display panel (10) of claim 1 or claim 2, wherein at least one of the plurality of color filters (620R, 620G, 620B) and/or at least a portion of the light-blocking layer (610) comprise scattering particles (642).

4. The display panel (10) of one of the preceding claims, wherein one surface of at least one of the plurality of color filters (620R, 620G, 620B) is curved.

5. The display panel (10) of one of the preceding claims, further comprising a waterrepellent layer (650) arranged on the light-blocking layer (610).

6. The display panel (10) of one of the preceding claims, wherein an upper surface of the light-blocking layer (610) is arranged at a point above or at a same level as a highest point of each of the plurality of color filters (620R, 620G, 620B).

7. The display panel (10) of one of the preceding claims, wherein the refractive layer (630) comprises low-refractive particles (632).

8. The display panel (10) of one of the preceding claims, wherein the refractive layer (630) comprises an upper substrate (633) arranged over the light-blocking layer (610) and spaced apart from each of the plurality of color filters (620R, 620G, 620B), wherein a gas layer (634) is disposed between the upper substrate (633) and each of the plurality of color filters (620R, 620G, 620B).

9. The display panel of (10) one of the preceding claims, further comprising an input sensing layer arranged over the refractive layer (630) or between each of the plurality of color filters (620R, 620G, 620B) and the encapsulation member (400).

10. The display panel (10) one of the preceding claims,
wherein the light-blocking layer is a first light-blocking layer (610) arranged over the encapsulation member (400) and comprising a plurality of first opening portions respectively corresponding to the plurality of display elements;
the plurality of color filters (620R, 620G, 620B) respectively is arranged in the plurality of first opening portions to respectively correspond to the plurality of display elements; and further comprising
a second light-blocking layer (670) arranged over the plurality of color filters (620R, 620G, 620B) and comprising a plurality of second opening portions respectively corresponding to the plurality of first opening portions; and
wherein the refractive layer (630) is arranged in each of the plurality of second opening portions and/or over the plurality of second opening portions.

11. The display panel of claim 10, further comprising a scattering layer (640) arranged between the first light-blocking layer (610) and the encapsulation member (400) and overlapping at least one of the plurality of display elements.

12. The display panel of claim 10 or claim 11, wherein at least one of the plurality of color filters, at least a portion of the first light-blocking layer (610), and/or at least a portion of the second light-blocking layer (670) comprise scattering particles (642).

13. The display panel of one of claims 10 to 12, wherein the refractive layer (630) comprises an upper substrate (633) arranged over the second light-blocking layer (670) and spaced apart from each of the plurality of color filters, wherein a gas layer (634) is disposed over each of the plurality of color filters.

14. An electronic apparatus (1) comprising:
the display panel (10) of one of the preceding claims; and
a display circuit board (30) connected to the display panel.
